(19) Europäisches Patentamt
European Patent Office
Office européen des brevets

(11) EP 1 079 668 A2

(12) **EUROPEAN PATENT APPLICATION**

(43) Date of publication:
**28.02.2001 Bulletin 2001/09**

(51) Int. Cl.[7]: **H05B 33/22**, H01L 51/20

(21) Application number: **00306805.3**

(22) Date of filing: **09.08.2000**

(84) Designated Contracting States:
**AT BE CH CY DE DK ES FI FR GB GR IE IT LI LU MC NL PT SE**
Designated Extension States:
**AL LT LV MK RO SI**

(30) Priority: **20.08.1999 JP 23346499**

(71) Applicant: **TDK Corporation**
**Chuo-ku, Tokyo 103-8272 (JP)**

(72) Inventors:
- **Codama, Mitsufumi**
**Tokyo 103-8272 (JP)**
- **Takaku, Munehiro**
**Tokyo 103-8272 (JP)**
- **Morita, Tsuyoshi**
**Tokyo 103-8272 (JP)**
- **Mizutani, Yosuke**
**Tokyo 103-8272 (JP)**

(74) Representative:
**Wise, Stephen James et al**
**c/o RAWORTH, MOSS & COOK,**
**Raworth House,**
**36 Sydenham Road**
**Croydon, Surrey CR0 2EF (GB)**

(54) **El display apparatus**

(57) In an EL display apparatus, strips of a color filter are arranged in parallel on a light output side of an EL device unit. Light emitted by the EL device unit is transmitted by at least two different color filters inclusive of a colorless filter to constitute a display unit. A display apparatus using a reduced number of filter materials and capable of displaying a greater number of colors than the number of filter materials is accomplished at a low cost.

FIG. 1

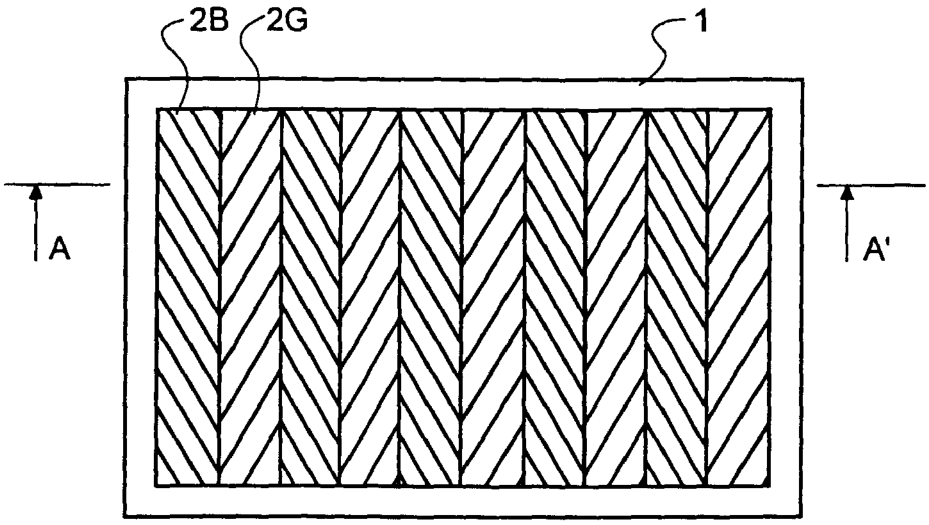


EP 1 079 668 A2

## Description

This invention relates to the structure of an electroluminescent (EL) display device and a method of preparing the same and more particularly, to a multi-color display function.

BACKGROUND OF THE INVENTION

In dot matrix type displays, a variety of colors can be synthesized by combining the light intensities of dots of red (R), green (G) and blue (B) constituting a display unit or pixel.

To display numerals and alphabets, display units are generally combined to constitute a 7- or 11-segment display which is usually monochromatic. In order to display different colors at different positions on a display panel, light emitting devices of plural colors or a plurality of filters must be formed. The same situation applies to display panels on audio-visual equipment including household and automotive audio sets, video cassette recorders, laser disc players, and DVD players.

In general, for self light emitting display apparatus, it is expensive to form devices capable of emitting light of different colors. It is a common practice for a conventional segment type display to produce multi-color display by combining a monochromatic light emitting device with color or fluorescent filters. To this end, a number of filters corresponding to the number of display colors are necessary.

A design wherein one segment is constituted by a plurality of pixels enables to represent a plurality of colors like the dot matrix type display.

The method of producing dot matrix type displays capable of producing a plurality of emission colors is disclosed, for example, in JP-A 5-258859, 8-227276, 8-315981, 9-102393, 10-223371 and USP 5,641,611.

In the methods of JP-A 5-258859, 8-227276, 8-315981, 9-102393, 10-223371 and USP 5,641,611, however, expensive light emissive materials must be deposited three times for RGB colors by a thin film technology such as vacuum evaporation. In particular, the methods of JP-A 5-258859, USP 5,641,611 and JP-A 10-223371 utilize barrier walls projecting on a substrate in combination with an oblique evaporation technique for depositing any material only on a selected region while preventing the evaporating material from depositing on one of opposed electrodes. These methods are generally very difficult to apply to a mass production process using a glass substrate of at least 300 mm long on one side.

The displays manufactured by these methods involving the deposition of multi-color light emissive materials require a drive circuit similar to the drive circuit used in dot matrix displays for driving a multiplicity of pixels and hence, a great expense. These methods also require the respective pixels to be electrically isolated from one another and hence, a somewhat wide non-light-emitting region which in turn, reduces an effective display region (known as an aperture ratio in the liquid crystal display art), resulting in a dark display.

When the fault mode that the display region gradually shrinks over long-term operation, which is a typical failure of organic EL devices, is taken into account, reducing the size of one device serving as a light emitting unit means that the device will earlier cease to emit light. Then the above-described structure in which one segment is constructed by a plurality of devices is undesirable from the reliability standpoint.

As previously described, in the above methods, expensive organic materials must be deposited several times, requiring a great expense.

More particularly, the prior art requires a number of filter film forming steps corresponding to the number of display colors. Then a display with a great information capacity capable of displaying a number of colors becomes expensive.

SUMMARY OF THE INVENTION

An object of the invention is to provide an EL display apparatus which can afford at a low cost a display apparatus using a reduced number of filter materials and capable of representing a greater number of colors than the number of filter materials.

The above and other objects are achieved by the present invention which is defined below.

(1) An EL display apparatus comprising an EL device unit having a light output side and at least two different color filters inclusive of a colorless filter arranged in parallel on the light output side, wherein light emitted by the EL device unit is transmitted by the at least two different color filters to constitute a display unit.

(2) The EL display apparatus of (1) wherein said color filters are chromatic color filters or fluorescent conversion filters.

(3) The EL display apparatus of (1) or (2) wherein said color filters are arranged in a stripe, mosaic or delta pattern.

(4) The EL display apparatus of (1) to (3) wherein the light emitted by the EL device unit is monochromatic.

(5) The EL display apparatus of (1) to (4) wherein the light emitted by the EL device unit is generally white.

(6) The EL display apparatus of (1) to (5) capable of displaying at least four colors.

(7) The EL display apparatus of (1) to (6) wherein any one of the color filters includes a portion which is transparent to at least visible light so that the light emitted by the EL device unit is transmitted by the transparent portion to the outside without a substantial change of its color.

(8) The EL display apparatus of (1) to (7) wherein the tone of the display unit is adjusted by the ratio in surface area between said at least two different color filters.

(9) The EL display apparatus of (1) to (8) wherein said EL device unit includes a portion having a light emitting capability, which portion is comprised primarily of an organic material.

(10) The EL display apparatus of (9) wherein the portion having a light emitting capability contains a dopant, and the tone of the display unit is adjusted by the concentration of the dopant.

(11) The EL display apparatus of (1) to (10) including a segment display portion and a dot matrix display portion, the number of color filter materials in the segment display portion being smaller than the number of color filter materials in the dot matrix display portion.

## BRIEF DESCRIPTION OF THE DRAWINGS

FIG. 1 is a plan view illustrating a first exemplary arrangement of color filters.
FIG. 2 is a cross-sectional view taken along lines A-A' in FIG. 1.
FIG. 3 is a plan view illustrating a second exemplary arrangement of color filters.
FIG. 4 is a cross-sectional view taken along lines A-A' in FIG. 3.
FIG. 5 is a plan view illustrating a third exemplary arrangement of color filters.
FIG. 6 is a cross-sectional view taken along lines A-A' in FIG. 5.
FIG. 7 is a plan view illustrating the arrangement of color filters in Example 1.
FIG. 8 is a cross-sectional view taken along lines A-A' in FIG. 7.
FIG. 9 is a plan view illustrating a transparent conductive film lying over the color filter arrangement in Example 1.
FIG. 10 is a cross-sectional view taken along lines A-A' in FIG. 9.
FIG. 11 is a plan view illustrating an organic layer lying over the color filter arrangement in Example 1.
FIG. 12 is a cross-sectional view taken along lines A-A' in FIG. 11.
FIG. 13 is a plan view illustrating a cathode lying over the color filter arrangement in Example 1.
FIG. 14 is a cross-sectional view taken along lines A-A' in FIG. 13.
FIG. 15 is a plan view illustrating a panel of Example 2.

## DESCRIPTION OF THE PREFERRED EMBODIMENT

The invention generally pertains to an electroluminescent (EL) display apparatus having strips of one or more color filters arranged in parallel on the light output side of an EL device unit. According to the invention, light emitted by the EL device unit is transmitted by at least two different color filters (inclusive of a colorless filter) to constitute a display unit.

To take out only a selected spectrum from an EL device capable of light emission whose spectrum covers a wide wavelength region, the use of a color filter is a common practice. In the manufacture of a display panel using an organic EL device capable of white light emission and color filters of three primary colors RGB, when it is desired to manufacture a device which can represent an additional color (e.g., purple) other than the three colors, red and blue filter segments of a sufficiently smaller size than the device are alternately arranged on the light output side of the device. Since it is unnecessary to divide the light emitting device itself into plural sections, operation can continue over a longer term even upon occurrence of the fault that the light emitting region shrinks.

The EL display apparatus of the invention has items of one or more color filters arranged in parallel on the light output side of an EL device unit.

The EL device unit means an EL device element which is a minimum display element. For example, when the EL device is divided into a plurality of pixels or segments, the EL device unit denotes the portion of the EL device that constitutes an individual pixel or segment.

As the color filter, any of color filters used in liquid crystal displays may be used. The properties of a color filter may be adjusted in accordance with the light emitted by the EL device for optimizing the extraction efficiency and color purity.

It is also preferred to use a color filter capable of cutting external light of short wavelength which is otherwise absorbed by the EL device materials or fluorescent conversion layer, because the light resistance and display contrast

of the device are improved. An optical thin film such as a dielectric multilayer film may be used instead of the color filter.

The fluorescent conversion filter film is to convert the color of light emission by absorbing electroluminescence and allowing the fluorescent material in the film to emit light. It is formed from three components: a binder, a fluorescent material, and a light absorbing material. The fluorescent material used may basically have a high fluorescent quantum yield and desirably exhibits strong absorption in the electroluminescent wavelength region. In practice, laser dyes are appropriate. Use may be made of rhodamine compounds, perylene compounds, cyanine compounds, phthalocyanine compounds (including sub-phthalocyanines), naphthalimide compounds, fused ring hydrocarbon compounds, fused heterocyclic compounds, styryl compounds, and coumarin compounds. The binder is selected from materials which do not cause extinction of fluorescence, preferably those materials which can be finely patterned by photolithography or printing technique. Also, where the filter film is formed on the substrate so as to be contiguous to the hole injecting electrode, those materials which are not damaged during deposition of the hole injecting electrode (such as ITO or IZO) are preferable. The light absorbing material is used when the light absorption of the fluorescent material is short and may be omitted if unnecessary. The light absorbing material may also be selected from materials which do not cause extinction of fluorescence of the fluorescent material.

The EL device unit emits light which is transmitted by at least two different color filters (inclusive of a colorless filter) to constitute a display unit. When light is transmitted by two or more different color filters, two or more colors are mutually combined or mixed within the display unit, enabling to display a united color which differs from the color of light emission and from the colors of the color filters themselves. The color filters may be chromatic color filter or colorless filters which permit the emitted light to pass therethrough as such.

The display unit means an image screen or display element which is a minimum display element. For example, when the display is divided into a plurality of pixels or segments, the display unit denotes the portion of the display that constitutes an individual pixel or segment. In this display unit portion, the light rays transmitted by two or more filters are integrally mixed or united so as to be perceived as a single color by the viewer.

The color of a color filter is determined by the combination of the color of EL light emission and the color of the filter itself, so as to comply with the desired display color. For example, when it is desired to produce sky blue or cyan color, a set of green and blue filters, a set of a blue filter and a filter-less portion, or a set of a green filter, a blue filter and a filter-less portion are arranged within the EL device unit or display unit.

The EL device units and display units are disposed in a stripe, delta, mosaic or other arrangement. The stripe, delta, and mosaic arrangements refer to the arrangements of color dots described, for example, in "Dictionary of Liquid Crystal Display Manufacture Technology Terms," Semiconductor Equipment Association of Japan Ed., Nikkan Kogyo Shinbun, page 61. Only the display of R, G and B colors is described in this dictionary although the invention is not limited thereto.

A desired color tone is selected by adjusting the location of the filters within the EL device unit or display unit and the ratio in size or surface area between the filters. Although the size of filters differs depending on a particular purpose of the panel, the size at which an individual filter is not clearly perceivable to the naked eyes on use is recommended. For example, when the viewer is relatively close to the panel at a distance of several tens of centimeters to about 1 meter, it is preferred to arrange filters with an area of up to 0.25 $mm^2$, more preferably 0.1 to 0.0001 $mm^2$ in a delta or mosaic arrangement and to arrange filters at a pitch of up to 500 $\mu$m, more preferably 300 to 50 $\mu$m in a stripe arrangement. Since the intensity of light transmitted by a filter varies with the color of the filter, a dark color filter should have a greater area or width, and a transparent or bright color filter should have a reduced area or width. The filters may be spaced apart from one another or partially overlapped. The overlapping arrangement must be designed while taking into account the fact that the overlapped portion is less transmissive to light.

An overcoat is preferably formed on the color filters so as to provide a flat surface over the color filters. The overcoat may be formed by coating a suitable resin or spin on glass (SOG). When a resin coating is employed, it is desired to form further thereon a protective film of an inorganic material such as $SiO_2$, SiON, SiNx, $Al_2O_3$ or aluminum nitride. These film forming techniques are already practiced in the color liquid crystal display art.

The light emitted by the EL device unit is preferably monochromatic or white. It is possible that the EL device unit produces plural light emissions although the device structure becomes complicated and expensive organic materials must be used extra. The light emitted by the EL device varies with a particular EL device structure. A typical organic EL device emits white light in the wavelength range of 400 to 700 nm or monochromatic light in the wavelength range of 400 to 600 nm or 500 to 700 nm.

Referring to the drawings, illustrative embodiments of the EL display apparatus according to the invention are described.

FIGS. 1 and 2 illustrate a first embodiment of the EL display apparatus according to the invention. FIG. 1 is a plan view and FIG. 2 is a cross-sectional view along lines A-A' in FIG. 1.

In this embodiment, blue filter strips 2B and green filter strips 2G are disposed on a substrate 1 in a stripe arrangement. An EL device 10 emits generally white light which is transmitted by these filter strips 2B and 2G whereupon the transmitted light is perceivable in pale blue or sky blue (cyan) color.

FIGS. 3 and 4 illustrate a second embodiment of the EL display apparatus according to the invention. FIG. 3 is a plan view and FIG. 4 is a cross-sectional view along lines A-A' in FIG. 3.

In this embodiment, blue filter strips 2B and an overcoat layer 3 are formed on a substrate 1. The blue filter strips 2B and filter-less portions consisting solely of the overcoat layer are disposed in a stripe arrangement. An EL device 10 emits generally white light which is transmitted by these filter strips 2B and overcoat layer portions 3 whereupon the transmitted light is perceivable in pale blue or sky blue (cyan) color.

FIGS. 5 and 6 illustrate a third embodiment of the EL display apparatus according to the invention. FIG. 5 is a plan view and FIG. 6 is a cross-sectional view along lines A-A' In FIG. 5.

In this embodiment, blue filter strips 2B, green filter strips 2G and an overcoat layer 3 are formed on a substrate 1. The blue filter strips 2B, green filter strips 2G and filter-less portions consisting solely of the overcoat layer are disposed in a stripe arrangement. An EL device 10 emits generally white light which is transmitted by these filter strips 2B, 2G and overcoat layer portions 3 whereupon the transmitted light is perceivable in sky blue (cyan) color.

These embodiments are merely illustrative of the present invention. Any of these embodiments and other modifications may be selected depending on the color of light emission of the EL device and the desired display color.

The EL device unit is preferably constructed by a device capable of broad flat light emission. Illustratively, the electroluminescent (EL) devices include inorganic EL devices using an inorganic material in a light emitting layer and organic EL devices using an organic material in at least a light emitting layer. The use of organic EL devices is preferred in the practice of the invention.

<u>Organic EL device</u>

The structure of the organic EL device is not critical as long as it emits ordinary monochromatic light or white light. One preferred device structure has a blue light emitting layer which contains as the host material a hole injecting and transporting compound and/or electron injecting and transporting compound which is contained in a hole transporting layer and/or electron transporting layer disposed adjacent to the light emitting layer. Another preferred device structure has a blue light emitting layer and uses an alkali metal chloride or oxide as a cathode material. More preferred is a combination of these device structures wherein the blue light emitting layer is a mixed layer of a hole injecting and transporting compound and an electron injecting and transporting compound.

<u>Blue light emitting layer</u>

The organic EL device used herein preferably has a blue light emitting layer. The blue light emissive compound used therein is preferably selected from phenylanthracene derivatives, which are described in USP 5,635,569 or EP 0681019. The preferred phenylanthracene derivatives are of the following general formula (A):

$$A_1\text{-}L\text{-}A_2 \qquad (A)$$

wherein each of $A_1$ and $A_2$, which may be identical or different, is a mono(ortho-substituted phenyl)anthryl or di(ortho-substituted phenyl)anthryl group, and L is a valence bond or a divalent linkage group.

The mono(ortho-substituted phenyl)anthryl or di(ortho-substituted phenyl)anthryl group represented by $A_1$ and $A_2$ has an aryl group, heteroaromatic ring group or arylethenyl group at the 2- or 6-position of the phenyl group (that is, at the ortho-position relative to the attachment to the anthracene ring). It may have a substituent other than at the ortho-position. Where substituted, exemplary substituents include alkyl, aryl, arylethenyl, alkoxy, and amino groups, which may be further substituted. These substituents will be described later.

Preferably the phenyl group is bonded to the anthracene ring at its 9- or 10-position.

In formula (A), L is a valence bond or a divalent linkage group. The preferred divalent linkage group is an arylene group which may be separated by an alkylene group, as will be described later.

Preferred among the phenylanthracene derivatives of formula (A) are those of formulae (A-1) and (A-2).

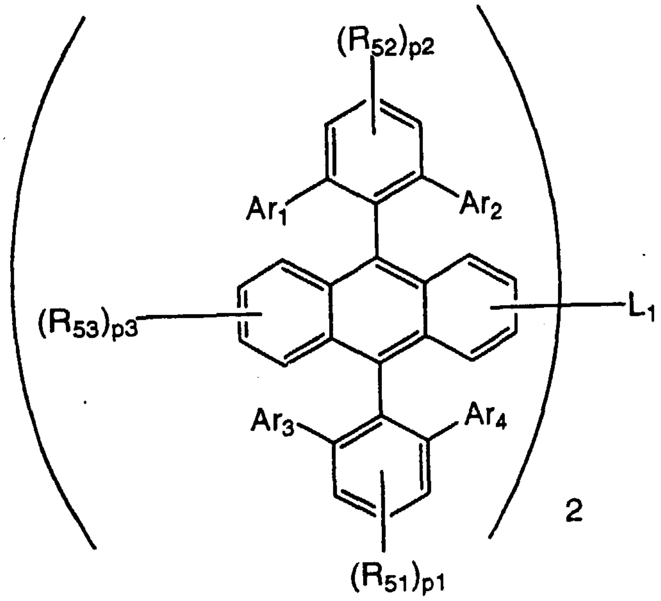

(A-1)

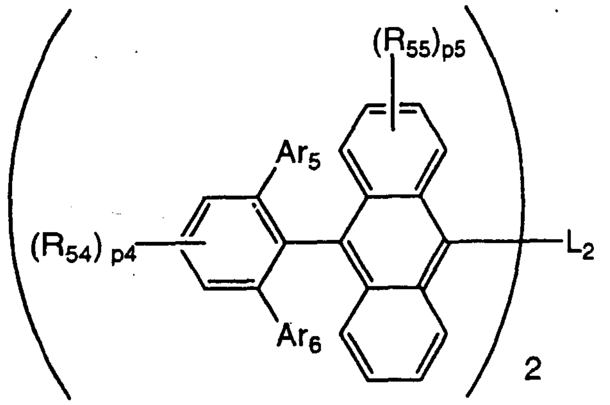

(A-2)

In formula (A-1), $Ar_1$ to $Ar_4$ each represent hydrogen, an aryl group, heteroaromatic ring group or arylethenyl group. At least one of $Ar_1$ and $Ar_2$, and at least one of $Ar_3$ and $Ar_4$ each are an aryl, heteroaromatic or arylethenyl group. $R_{51}$ and $R_{52}$, which may be the same or different, each represent an alkyl, aryl, arylethenyl, alkoxy or amino group. Letters p1 and p2 each are an integer of 0 to 3. The $R_{51}$ groups and $R_{52}$ groups may be the same or different, respectively, where p1 and p2 are integers of at least 2. $R_{53}$ represents an alkyl or aryl group, and p3 is an integer of 0 to 3. The $R_{53}$ groups may be the same or different where p3 is an integer of at least 2. $L_1$ is a valence bond or an arylene group which may be separated by an alkylene group, -O-, -S- or -NR- wherein R is alkyl or aryl.

In formula (A-2), $Ar_5$ and $Ar_6$ each represent hydrogen, an aryl group, heteroaromatic ring group or arylethenyl group. At least one of $Ar_5$ and $Ar_6$ is an aryl, heteroaromatic or arylethenyl group. $R_{54}$ represents an alkyl, aryl, arylethenyl, alkoxy or amino group, and p4 is an integer of 0 to 3. The $R_{54}$ groups may be the same or different where p4 is an integer of at least 2. $R_{55}$ represents an alkyl or aryl group, and p5 is an integer of 0 to 4. The $R_{55}$ groups may be the same or different where p5 is an integer of at least 2. $L_2$ is a valence bond or an arylene group which may be separated by an alkylene group, -O-, -S- or -NR- wherein R is alkyl or aryl.

The aryl groups represented by $Ar_1$ to $Ar_4$ and $R_{51}$ to $R_{53}$ are preferably those of 6 to 20 carbon atoms and may have substituents such as phenyl and tolyl. Exemplary are phenyl, o-, m- and p-tolyl, pyrenyl, naphthyl, anthryl, biphenyl, phenylanthryl, and tolylanthryl.

The preferred heteroaromatic ring groups represented by $Ar_1$ to $Ar_4$ are furyl, benzofuryl, thienyl, bithienyl, benzothienyl, pyrrolyl, N-allylpyrrolyl, indolyl, pyridyl, bipyridyl, quinolyl, quinoxalyl, oxazole, benzoxazole, oxadiazole, thiazole, benzthiazole, thiadiazole, and imidazole groups. These groups may have substituents such as aryl groups of

up to 42 carbon atoms, alkyl groups of up to 12 carbon atoms, alkoxy, aryloxy, amino, cyano, and nitro groups. Illustrative substituents include phenyl, o-, m- and p-biphenyl, 1- or 2-naphthyl, methyl, ethyl, propyl, butyl, methoxy, ethoxy, phenoxy and o-, m- and p-tolyl.

The preferred arylethenyl groups represented by $Ar_1$ to $Ar_4$, $R_{51}$ and $R_{52}$ are 2-phenylethenyl and 2,2-diphenylethenyl. These groups may have substituents such as aryl, alkyl, alkoxy, aryloxy, amino, cyano, and nitro groups. Illustrative substituents include phenyl, o-, m-and p-biphenyl, 1- or 2-naphthyl, methyl, ethyl, propyl, butyl, methoxy, ethoxy, phenoxy and o-, m- and p-tolyl.

The alkyl groups represented by $R_{51}$ to $R_{53}$ may be straight or branched. Substituted or unsubstituted alkyl groups of 1 to 10 carbon atoms, especially 1 to 4 carbon atoms are preferred, with unsubstituted alkyl groups of 1 to 4 carbon atoms being especially preferred. Illustrative examples include methyl, ethyl, n- and i-propyl, n-, i-, s-and t-butyl.

The alkoxy groups represented by $R_{51}$ and $R_{52}$ are those having an alkyl moiety of 1 to 6 carbon atoms. Methoxy and ethoxy groups are exemplary. The alkoxy groups may have substituents.

The amino groups represented by $R_{51}$ and $R_{52}$ may be either substituted or unsubstituted, with substituted amino groups being preferred. Exemplary substituents are alkyl groups such as methyl and ethyl and aryl groups such as phenyl. Examples of the amino group include diethylamino, diphenylamino, and di(m-tolyl)amino groups.

In formula (A-1), p1 and p2 each are 0 or an integer of 1 to 3, and preferably equal to 0, 1 or 2. $R_{51}$ and $R_{52}$ each are preferably methyl or phenyl where p1 and p2 are integers of 1 to 3, especially 1 or 2.

In formula (A-1), p3 is an integer of 0 to 3, and preferably equal to 0, 1 or 2. $R_{53}$ is preferably methyl or phenyl where p3 is an integer of 1 to 3, especially 1 or 2.

In formula (A-1), $R_{51}$ to $R_{53}$ may be the same or different. Where a plurality of $R_{51}$ groups, $R_{52}$ groups and $R_{53}$ groups are included, the $R_{51}$ groups, the $R_{52}$ groups and the $R_{53}$ groups may be the same or different, respectively.

In formula (A-1), $L_1$ is a valence bond or an arylene group. The arylene group represented by $L_1$ is preferably an unsubstituted one. Examples include ordinary arylene groups such as phenylene, biphenylene, and anthrylene while two or more directly bonded arylene groups are also included. Preferably $L_1$ is a valence bond, p-phenylene group, and 4,4'-biphenylene group.

The arylene group represented by $L_1$ may be a group having two arylene groups separated by an alkylene group, - O-, -S- or -NR-. R is an alkyl or aryl group. Exemplary alkyl groups are methyl and ethyl and an exemplary aryl group is phenyl. Preferably R is an aryl group which is typically phenyl as just mentioned while it may be $A_1$ or $A_2$ or phenyl having $A_1$ or $A_2$ substituted thereon. Preferred alkylene groups are methylene and ethylene groups.

Examples of the arylene group represented by $L_1$ are shown below.

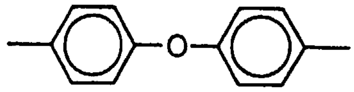

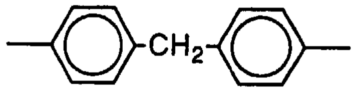

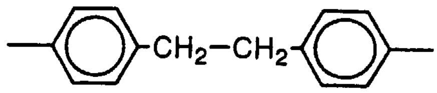

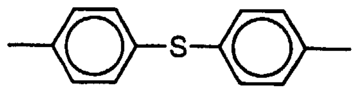

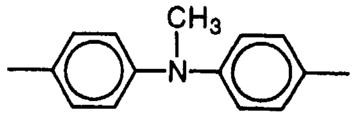

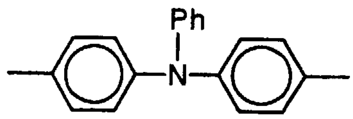

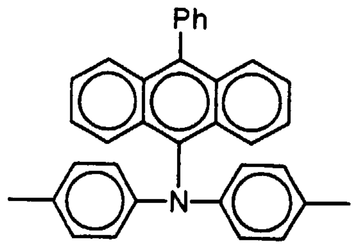

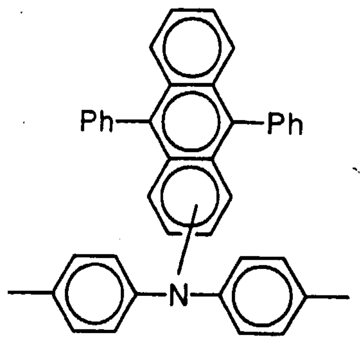

Next, formula (A-2) is described.

In formula (A-2), $R_{54}$ is as defined for $R_{51}$ and $R_{52}$ in formula (A-1), $R_{55}$ is as defined for $R_{53}$ in formula (A-1), p4 is as defined for p1 and p2 in formula (A-1), and $L_2$ is as defined for $L_1$ in formula (A-1). Their preferred examples are also the same.

In formula (A-2), p5 is an integer of 0 to 4, especially equal to 0, 1 or 2. $R_{55}$ is preferably methyl or phenyl where p5 is an integer of 1 to 3, especially 1 or 2.

In formula (A-2), $R_{54}$ and $R_{55}$ may be the same or different. Where a plurality of $R_{54}$ groups and $R_{55}$ groups are included, the $R_{54}$ groups and the $R_{55}$ groups may be the same or different, respectively.

In formula (A-1), at least one of $Ar_1$ and $Ar_2$, and at least one of $Ar_3$ and $Ar_4$ each are preferably a phenyl, biphenyl, terphenyl, styryl, phenylstyryl, diphenylstyryl, thienyl, methylthienyl, phenylthienyl or phenylbithienyl group. Further preferably, at least one of $Ar_1$ and $Ar_2$, and at least one of $Ar_3$ and $Ar_4$ each are a phenyl, biphenyl or terphenyl group, and $L_1$ is a valence bond.

In formula (A-2), at least one of $Ar_5$ and $Ar_6$ is preferably a phenyl, biphenyl, terphenyl, styryl, phenylstyryl, diphenylstyryl, thienyl, methylthienyl, phenylthienyl or phenylbithienyl group. Further preferably, at least one of $Ar_5$ and $Ar_6$ is a phenyl, biphenyl or terphenyl group, and $L_2$ is a valence bond.

For the synthesis of the phenylanthracene derivatives used herein, reference should be made to USP 5,635,569 or EP 0681019. The phenylanthracene derivatives may be used alone or in admixture of two or more.

Where the phenylanthracene derivative is used as a blue light emissive compound to construct a blue light emitting layer, the layer preferably has a thickness of about 1 to 500 nm, and more preferably about 10 to 200 nm.

If desired, the light emitting layer is doped with a dopant in such a manner that the blue light emission capability may be retained. Such dopants include styrylamine compounds as disclosed in WO 98/08360 and JP-A 8-239655. The styrylamine compounds are described later. The dopant is preferably used in an amount of 0.1 to 20% by weight based on the light emitting layer. The dopant is effective for improving luminous efficiency and device stability.

The blue light emitting layer may contain as a host material an electron injecting and transporting compound or hole injecting and transporting compound as used in an electron transporting layer or hole transporting layer disposed adjacent to the light emitting layer. More illustratively, a phenylanthracene derivative used in the electron transporting layer is used as the host material. The phenylanthracene derivative has a blue light emitting capability and can produce by itself blue light emission. In the event the host material does not possess a blue light emitting capability, a dopant is used to alter the light emitting capability of the host material so as to emit blue light. The styrylamine compound is a typical such dopant.

In such a construction, the electron or hole transporting layer containing a compound serving as the host material and the light emitting layer have such thicknesses that the ratio of the thickness of the light emitting layer to the thickness of the electron or hole transporting layer may range from 1/100 to 100/1.

The blue light emitting layer may be a mixed layer of an electron injecting and transporting compound and a hole injecting and transporting compound, which is a preferred embodiment. In particular, either one of the electron injecting and transporting compound and hole injecting and transporting compound is preferably the same compound as used in the electron or hole transporting layer disposed adjacent to the light emitting layer. Most preferably, the electron and hole transporting layers are disposed adjacent to the light emitting layer, and the light emitting layer is formed of a mixture of the electron and hole injecting and transporting compounds used in the electron and hole transporting layers, respectively.

In one preferred embodiment, a phenylanthracene derivative in the electron transporting layer is used as the electron injecting and transporting compound, and an aromatic tertiary amine in the hole transporting layer is used as the hole injecting and transporting compound. The phenylanthracene derivative used herein is preferably of the above-described formula (A) while the aromatic tertiary amine used herein is preferably a tetraarylbenzidine derivative of the following formula (1).

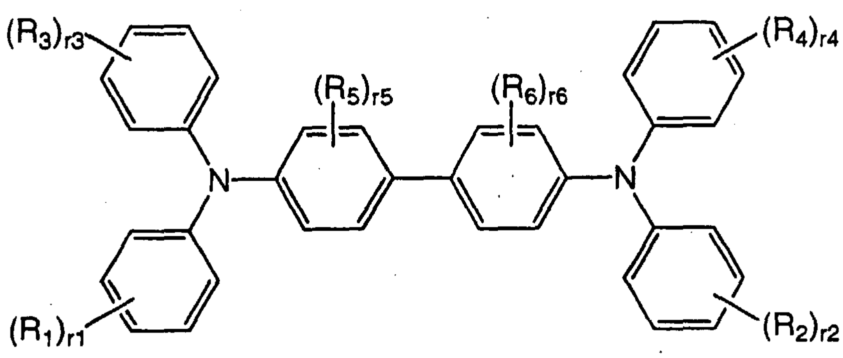

(1)

In formula (1), $R_1$ to $R_4$, which may be the same or different, are individually aryl groups, alkyl groups, alkoxy groups, aryloxy groups or halogen atoms. Letters r1 to r4 each are an integer of 0 to 5. When each of r1 to r4 is an integer of at least 2, the adjoining $R_1$ groups, $R_2$ groups, $R_3$ groups, and $R_4$ groups, taken together, may form a ring. $R_5$ and $R_6$, which may be the same or different, are individually alkyl groups, alkoxy groups, amino groups or halogen atoms. Letters r5 and r6 each are an integer of 0 to 4.

The aryl groups represented by $R_1$ to $R_4$ may be monocyclic or polycyclic, inclusive of fused rings and a collection of rings. Those aryl groups having 6 to 20 carbon atoms in total are preferred. The aryl groups may have substituents, with exemplary substituents including alkyl groups, alkoxy groups, aryl groups, aryloxy groups, amino groups and halogen atoms. Exemplary aryl groups are phenyl, o-, m- and p-tolyl, pyrenyl, perillenyl, coronenyl, naphthyl, anthryl, biphenylyl, phenylanthryl, and tolylanthryl, with the phenyl being especially preferred. The aryl group, especially phenyl is preferably attached at the 3-position (meta-position to the position of N bond) or 4-position (para-position to the position of N bond).

The alkyl groups represented by $R_1$ to $R_4$ may be straight or branched, are preferably those of 1 to 10 carbon atoms. The alkyl groups may have substituents, examples of which are as exemplified above for the aryl groups. Exemplary alkyl groups are methyl, ethyl, n- and i-propyl, and n-, i-, s- and t-butyl.

The alkoxy groups represented by $R_1$ to $R_4$ are preferably those having a $C_{1-6}$ alkyl moiety. Exemplary alkoxy groups are methoxy, ethoxy, and t-butoxy. The alkoxy groups may have substituents.

The aryloxy groups represented by $R_1$ to $R_4$ include phenoxy, 4-methylphenoxy and 4-(t-butyl)phenoxy groups.

The halogen atoms represented by $R_1$ to $R_4$ include chlorine and bromine atoms.

In one preferred example of formula (1), any one of r1 to r4 is an integer of at least 2, and any pair of the $R_1$ groups, $R_2$ groups, $R_3$ groups or $R_4$ groups, taken together, form a ring (e.g., benzene ring).

In another preferred example, at least one of $R_1$ to $R_4$ is an aryl group. Namely, it is excluded that r1 to r4 are equal to 0 at the same time. Therefore, the sum of r1+r2+r3+r4 is an integer of at least 1 satisfying the condition that at least one aryl group is present.

In the example wherein at least one of $R_1$ to $R_4$ is an aryl group, it is preferred that two to four aryl groups are included in a molecule as $R_1$ to $R_4$ and that two to four of r1 to r4 are integers of at least 1. It is more preferred that two to four aryl groups in total are included in a molecule, and two to four of r1 to r4 are integers of at least 1. It is further preferred that r1 to r4 are equal to 1, and all of $R_1$ to $R_4$ included are aryl groups. Specifically, in the molecule, the four benzene rings which may have $R_1$ to $R_4$ substituted thereon have two to four aryl groups in total. The two to four aryl groups may be attached to the same or different ones of the four benzene rings, and more preferably, the two to four aryl groups are attached to different ones of the four benzene rings. Further preferably, at least two aryl groups are attached at the para or meta-position relative to the position of N bond. Of these aryl groups, at least one is preferably phenyl. Specifically stated, it is preferred that an aryl group and a benzene ring are taken together to form a 4- or 3-biphenylyl group relative to the nitrogen atom. It is especially preferred that two to four 4- or 3-biphenylyl groups are included in the molecule. Either one or both of 4- and 3-biphenylyl groups may be included. The aryl groups other than phenyl are preferably 1- or 2-naphthyl, 1-, 2- or 9-anthryl, pyrenyl, perillenyl, and coronenyl, and the aryl groups other than phenyl are preferably attached at the para or meta-position relative to the position of N bond. Such aryl groups may be incorporated in admixture with the phenyl groups.

In formula (1), the alkyl groups, alkoxy groups, and halogen atoms represented by $R_5$ and $R_6$ are as exemplified above for $R_1$ to $R_4$.

The amino groups represented by $R_5$ and $R_6$ may be substituted or unsubstituted, with substituted ones being preferred. Illustrative examples include dimethylamino, diethylamino, diphenylamino, ditolylamino, dibiphenylylamino, N-phenyl-N-tolylamino, N-phenyl-N-naphthylamino, N-phenyl-N-biphenylylamino, N-phenyl-N-anthrylamino, N-phenyl-N-pyrenylamino, dinaphthylamino, dianthrylamino and dipyrenylamino.

Preferably both r5 and r6 are equal to 0, that is, the biphenylene group interconnecting two arylamino groups is preferably an unsubstituted one.

When r1 to r4 are integers of at least 2, the $R_1$ groups, $R_2$ groups, $R_3$ groups and $R_4$ groups may respectively be the same or different. When r5 and r6 are integers of at least 2, the $R_5$ groups and $R_6$ groups may respectively be the same or different.

Preferred of these compounds are compounds of the following formula (1-1).

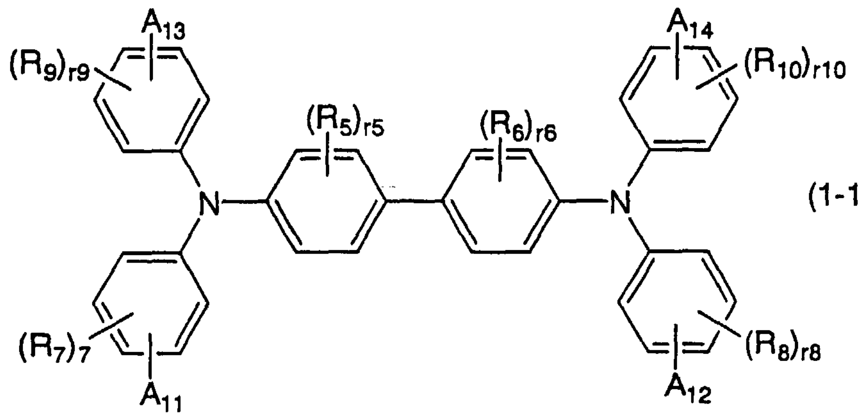

(1-1)

In formula (1-1), $A_{11}$ to $A_{14}$ independently represent a phenyl group or hydrogen atom which is attached at the para-position (4-position) or meta-position (3-position) relative to the position of N bond. $A_{11}$ to $A_{14}$ may be the same or different. It is preferred that at least two of $A_{11}$ to $A_{14}$ be phenyl groups. These phenyl groups may have substituents, examples of which are as exemplified for the aryl groups represented by $R_1$ to $R_4$ in formula (1).

$R_7$ to $R_{10}$ independently represent alkyl, alkoxy, aryl, aryloxy groups or halogen atoms. $R_7$ to $R_{10}$ may be the same or different. Examples of these groups are as exemplified for $R_1$ to $R_4$ in formula (1).

Letters r7 to r10 each are an integer of 0 to 4, with r7 to r10 being preferably equal to 0.

[00096]

When each of r7 to r10 is an integer of at least 2, the $R_7$ groups, $R_8$ groups, $R_9$ groups, and $R_{10}$ groups may be the same or different, respectively.

In formula (1-1), $R_5$, $R_6$, r5 and r6 are as defined in formula (1), with r5=r6=0 being preferred.

The tetraarylbenzidine derivatives of formula (1) may be used alone or in admixture of two or more.

In the mixed layer, the mixing ratio (volume ratio) of the electron injecting and transporting compound to the hole injecting and transporting compound is preferably from 10/90 to 90/10, and more preferably from 20/80 to 80/20.

When a phenylanthracene derivative as defined above is used as the electron transporting compound in such a mixed layer, the phenylanthracene derivative itself serves as a blue light emissive compound. When the phenylanthracene derivative is used as a blue light emissive compound and mixed with a tetraarylbenzidine derivative to form a blue light emitting layer, the mixing ratio (volume ratio) of the phenylanthracene derivative to the tetraarylbenzidine derivative is preferably from 95/5 to 30/70, especially from 90/10 to 40/60.

The mixed layer may be further doped with a dopant. The use of such a dopant is effective for improving luminous efficiency and device stability. An appropriate amount of the dopant is about 0.1 to 20% by weight of the mixed layer.

The preferred dopants are styrylamine compounds as previously described. Styrylamine compounds of the following formula (S) are especially preferred.

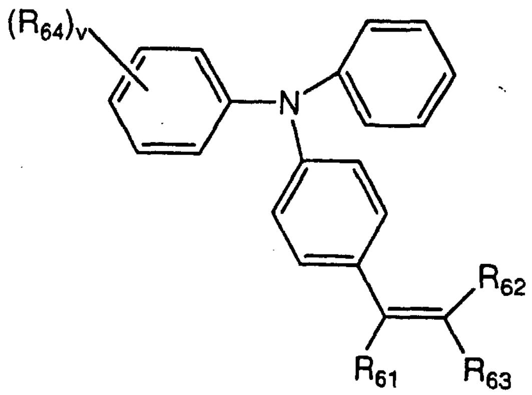

(S)

In formula (S), $R_{61}$ is hydrogen or an aryl group. The aryl group represented by $R_{61}$ may be substituted or

unsubstituted and preferably has 6 to 30 carbon atoms in total. Phenyl is an exemplary aryl group.

$R_{62}$ and $R_{63}$ independently represent hydrogen, aryl groups or alkenyl groups. $R_{62}$ and $R_{63}$ may be the same or different.

The aryl groups represented by $R_{62}$ and $R_{63}$ may be substituted or unsubstituted and preferably have 6 to 70 carbon atoms in total. Illustrative of the aryl groups are phenyl, naphthyl and anthryl while the preferred substituents thereon include arylamino and arylaminoaryl groups. Styryl-containing substituents are also preferable, and in such a case, a structure wherein monovalent groups derived from the compound of formula (S) are bonded together directly or via a linkage group is also preferable.

The alkenyl groups represented by $R_{62}$ and $R_{63}$ may be substituted or unsubstituted and preferably have 2 to 50 carbon atoms in total. Vinyl is typical. Vinyl forming styryl is preferable. In such a case, a structure wherein monovalent groups derived from the compound of formula (S) are bonded together directly or via a linkage group is also preferable.

$R_{64}$ represents an arylamino or arylaminoaryl group, which may contain a styryl group. In such a case, a structure wherein monovalent groups derived from the compound of formula (S) are bonded together directly or via a linkage group is also preferable.

Illustrative examples of the styrylamine compound of formula (S) are given below.

S-1

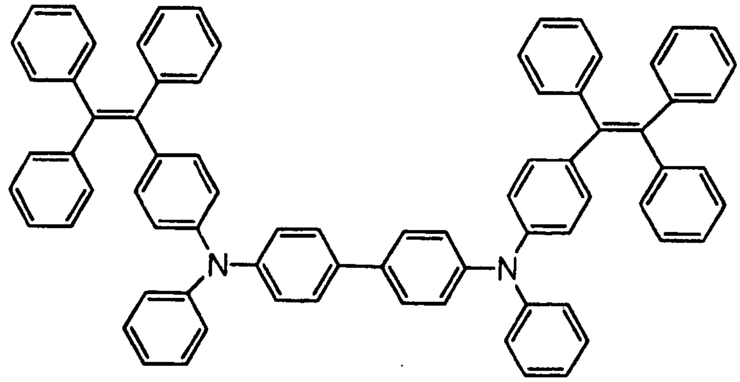

S-2

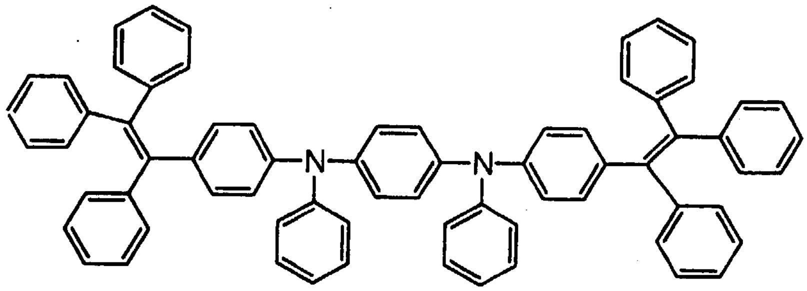

S-3

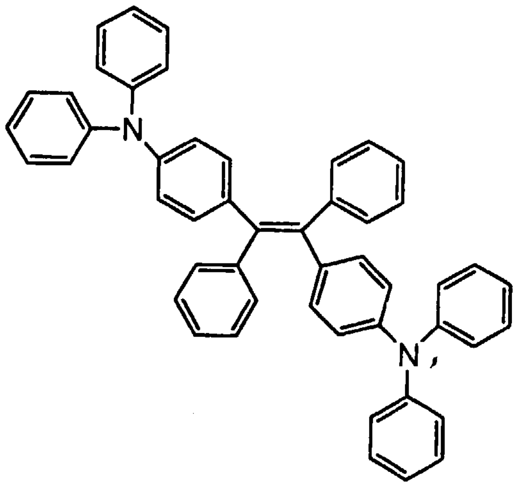

S-4

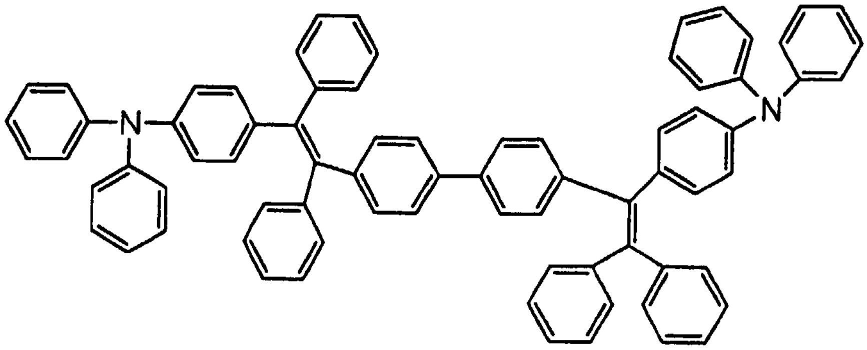

S-5

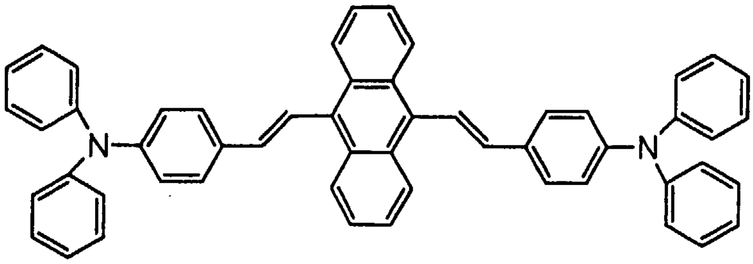

S-6

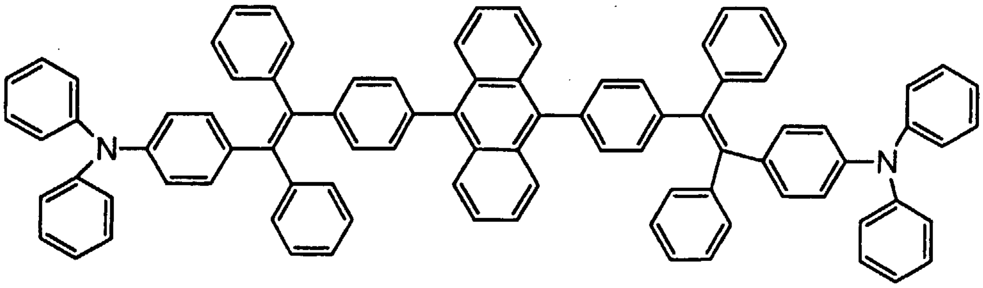

S-7

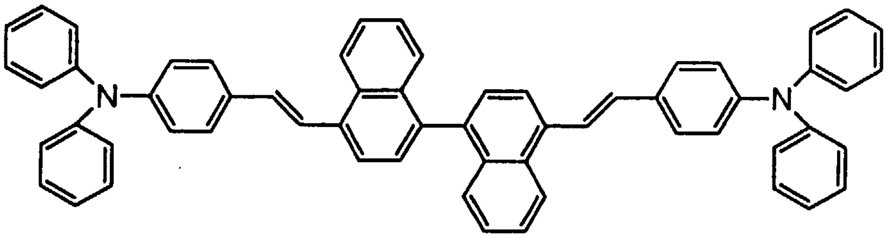

S-8

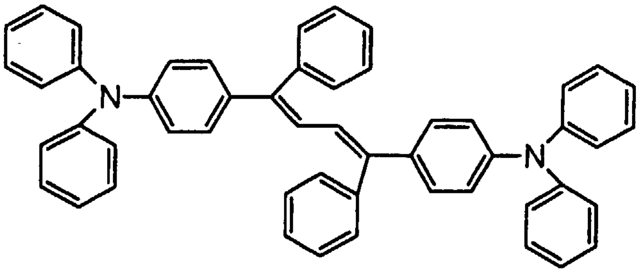

S-9

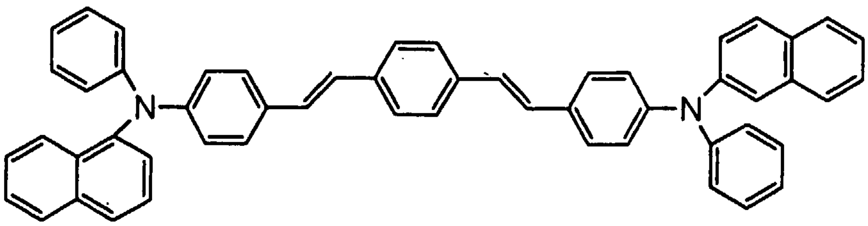

The styrylamine compounds may be used alone or in admixture of two or more.

In the mixed layer mentioned above, the electron injecting and transporting compound and the hole injecting and transporting compound are selected such that their products of a charge mobility by a charge density may be approximately equal. More preferably, their charge mobilities are approximately equal in addition to satisfying the above requirement. The charge mobility is determined by the time-of-flight method and preferably falls in the range of $1 \times 10^{-1}$ to $1 \times 10^{-5}$ $cm^2/V$-s. The choice of the compounds having close charge mobilities has the advantages that (1) increasing the recombination probability of carriers leads to an improved luminous efficiency and (ii) the spike-through of carriers

from the light emitting layer is reduced so that damage to the carrier transporting layer is reduced, prolonging the effective lifetime of the light emitting device. Mixing the electron injecting and transporting compound and the hole injecting and transporting compound has the advantage that the electron and hole mobilities are reduced and the recombination probability is increased.

In the mixed layer, the electron injecting and transporting compound and the hole injecting and transporting compound may be mixed uniformly. Alternatively, the mixed layer is a graded film having such a concentration distribution in a thickness direction that the concentration of hole injecting and transporting compound is higher on the side of the hole transporting layer, but gradually lowers toward the electron transporting layer and the concentration of electron injecting and transporting compound is higher on the side of the electron transporting layer, but gradually lowers toward the hole transporting layer. In the graded film, 95 to 50% by weight of the electron injecting and transporting compound in the entire mixed layer is preferably included in the one-half region of the mixed layer adjacent the electron transporting layer, and the same relationship applies to the hole injecting and transporting compound.

The blue light emitting layer constructed by the mixed layer mentioned above has the feature that electrons and holes are distributed throughout the light emitting layer so that recombination points and radiative points are spread throughout the light emitting layer whereby light emission takes place not only in proximity to interlayer interfaces, but throughout the mixed layer. This is readily ascertained by fitting an actually measured light emission spectrum on a light emission spectrum obtained by assuming light emitting regions and effecting optical interference simulation of reflected light and direct light at optical interfaces. Since the layer produces light emission over its entirety, the light emission of different wavelengths by stacked layers can be delivered from a single device in a stable manner, with the advantage of device longevity.

The blue light emitting layer used herein has a light emission maximum wavelength of 400 to 500 nm.

Preferably the mixed layer mentioned above has a thickness of about 1 to 500 nm, and more preferably about 20 to 200 nm.

<u>Other colors of light emission</u>

In addition to the blue light emitting layer, the organic EL device of the invention preferably has at least one light emitting layer capable of light emission at a different wavelength so that the device may allow for multi-color light emission. Such additional light emitting layers may emit red light (light emission maximum wavelength of 600 to 700 nm) and green light (light emission maximum wavelength of 500 to 560 nm).

Also preferably, the additional light emitting layer is a mixed layer using the same host material as the blue light emitting layer, to which a dopant is added so as to emit light of a different color from blue. Then the recombination region is spread, which is advantageous in creating excitons.

One preferred example of such a mixed layer is a layer formed of a mixture of the phenylanthracene derivative and the tetraarylbenzidine derivative and doped with a naphthacene derivative as a dopant. For example, use of rubrene as the naphthacene derivative enables emission of red light (light emission maximum wavelength of 540 to 600 nm). The addition of the naphthacene derivative has the additional advantage of device longevity. Besides, pentacene derivatives have similar advantages. These derivatives are described in JP-A 8-311442, WO 98/08360 and Japanese Patent Application No. 10-137505 (1998).

The preferred naphthacene derivatives are compounds of the following formula (N).

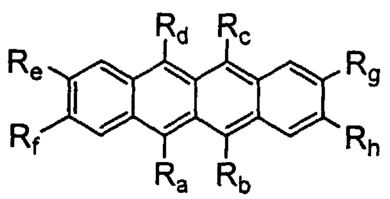

(N)

In formula (N), Ra, Rb, Rc and Rd independently represent substituted or unsubstituted alkyl, aryl, amino, heterocyclic or alkenyl groups, and preferably aryl, amino, heterocyclic or alkenyl groups.

The aryl groups represented by Ra, Rb, Rc and Rd may be monocyclic or polycyclic, inclusive of fused rings and a collection of rings. Those aryl groups having 6 to 30 carbon atoms in total are preferred. The aryl groups may have substituents.

Exemplary aryl groups represented by Ra, Rb, Rc and Rd are phenyl, o-, m- and p-tolyl, pyrenyl, perillenyl, coronenyl, 1- and 2-naphthyl, anthryl, o-, m- and p-biphenylyl, terphenyl and phenanthryl.

The amino groups represented by Ra, Rb, Rc and Rd include alkylamino, arylamino and aralkylamino

groups. These amino groups preferably have an aliphatic group of 1 to 6 carbon atoms and/or an aromatic carbocycle of one to four rings. Illustrative examples of the amino groups include dimethylamino, diethylamino, dibutylamino, diphenylamino, ditolylamino, bisdiphenylylamino, and bisnaphthylamino groups.

The heterocyclic groups represented by Ra, Rb, Rc and Rd include 5- or 6-membered aromatic heterocyclic groups containing O, N or S as a heteroatom, and fused polycyclic aromatic heterocyclic groups of 2 to 20 carbon atoms. Exemplary aromatic heterocyclic and fused polycyclic aromatic heterocyclic groups are thienyl, furyl, pyrrolyl, pyridyl, quinolyl and quinoxalyl groups.

The alkenyl groups represented by Ra, Rb, Rc and Rd are preferably those having at least one phenyl group as a substituent, for example, 1- and 2-phenylalkenyl, 1,2- and 2,2-diphenylalkenyl, and 1,2,2-triphenylalkenyl groups. Unsubstituted alkenyl groups are also included.

Where Ra, Rb, Rc and Rd have substituents, it is preferred that at least two of the substituents are aryl, amino, heterocyclic, alkenyl or aryloxy groups. The aryl, amino, heterocyclic and alkenyl groups are as defined above for Ra, Rb, Rc and Rd.

The aryloxy groups that substitute on Ra, Rb, Rc and Rd are preferably those having aryl groups of 6 to 18 carbon atoms in total. Exemplary are o-, m- and p-phenoxy groups.

Two or more of these substituents may form a fused ring together. Also the substituents may further have substituents thereon, preferred examples of which are the same as above.

Where Ra, Rb, Rc and Rd have substituents, it is preferred that at least two of the substituents have thereon substituents as mentioned above. The substitution position is not critical and may be the meta, para or ortho-position. It is preferred that Ra is identical with Rd, and Rb is identical with Rc although they may be different.

Re, Rf, Rg and Rh independently represent hydrogen or substituted or unsubstituted alkyl, aryl, amino or alkenyl groups.

The alkyl groups represented by Re, Rf, Rg and Rh are preferably those of 1 to 6 carbon atoms and may be straight or branched. Preferred examples of the alkyl group include methyl, ethyl, n- and i-propyl, n-, i-, sec- and tert-butyl, n-, i-, neo- and tert-pentyl groups.

The aryl, amino and alkenyl groups represented by Re, Rf, Rg and Rh are as defined above for Ra, Rb, Rc and Rd. It is preferred that Re is identical with Rf, and Rg is identical with Rh although they may be different.

An appropriate content of the naphthacene derivative is about 0.1 to 20% by weight of the mixed layer.

In such a mixed layer, the mixing ratio (volume ratio) of the phenylanthracene derivative to the tetraarylbenzidine derivative is preferably from 90/10 to 10/90. The mixed layer preferably has a thickness of about 1 to 500 nm, and more preferably about 10 to 200 nm.

In the preferred embodiment of the invention, the EL device has two or three light emitting layers including a blue light emitting layer so that the device may emit white light.

Hole transporting and/or injecting layer

In the preferred embodiment of the invention, the EL device has a hole transporting and/or injecting layer as previously described in part. In embodiments other than the embodiment wherein a hole transporting layer is provided and a hole injecting and transporting compound in that layer is used as a host material in the light emitting layer, it is yet preferred to provide a hole transporting and/or injecting layer (which is sometimes designated a hole injecting and transporting layer). In this case, the hole injecting and transporting compounds are preferably aromatic tertiary amine compounds, and more preferably tetraarylbenzidine derivatives of formula (1) and triphenylamine derivatives of the following formula (2). The formula (1) is already described. The formula (2) is described below.

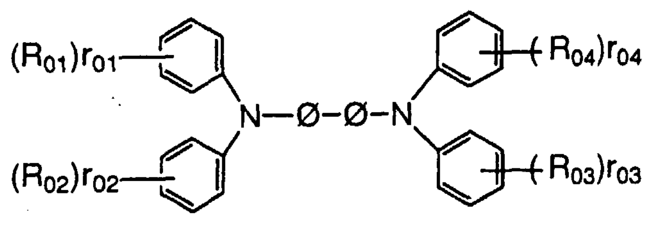

(2)

In formula (2), Φ represents phenylene. The biphenylene groups represented by Φ-Φ include 4,4'-biphenylene, 3,3'-biphenylene, 3,4'-biphenylene, 2,2'-biphenylene, 2,3'-biphenylene, and 2,4'-biphenylene, with the 4,4'-biphenylene being preferred.

$R_{01}$, $R_{02}$, $R_{03}$ and $R_{04}$ are independently diarylaminoaryl groups or groups represented by the following for-

mulae:

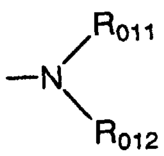,
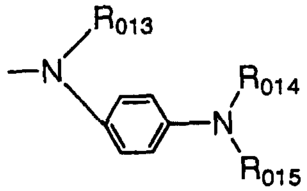
and
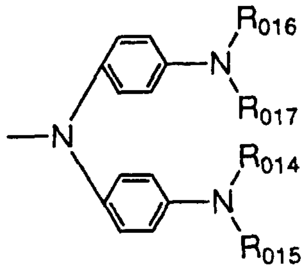

wherein $R_{011}$, $R_{012}$, $R_{013}$, $R_{014}$, $R_{015}$, $R_{016}$ and $R_{017}$ are aryl groups. $R_{01}$, $R_{02}$, $R_{03}$ and $R_{04}$ may be the same or different.

The aryl groups represented by $R_{011}$, $R_{012}$, $R_{013}$, $R_{014}$, $R_{015}$, $R_{016}$ and $R_{017}$ may be substituted or unsubstituted and monocyclic or polycyclic. Those aryl groups having 6 to 20 carbon atoms in total are preferred. Examples include phenyl, naphthyl, anthryl, phenanthryl, pyrenyl, perillenyl, and o-, m- and p-biphenyl groups. These aryl groups may further have substituents thereon. Such substituents include alkyl groups of 1 to 6 carbon atoms, substituted or unsubstituted aryl groups, alkoxy groups, aryloxy groups, and $-N(R_{021})R_{022}$ wherein $R_{021}$ and $R_{022}$ are substituted or unsubstituted aryl groups.

The aryl groups represented by $R_{021}$ and $R_{022}$ may be monocyclic or polycyclic, and have 6 to 20 carbon atoms in total. Examples include phenyl, naphthyl, anthryl, phenanthryl, pyrenyl, perillenyl, and o-, m- and p-biphenyl groups, with the phenyl group being preferred. These aryl groups may further have substituents thereon. Such substituents include alkyl groups of 1 to 6 carbon atoms (preferably methyl) and substituted or unsubstituted aryl groups (preferably phenyl).

Exemplary of the diarylaminoaryl groups represented by $R_{01}$, $R_{02}$, $R_{03}$ and $R_{04}$ are diarylaminophenyl groups. In such groups, the diarylamino group is preferably attached at the meta-position (3-position) or para-position (4-position) relative to the skeleton represented by formula (2). The phenyl group may have further substituents although the phenyl group having only the diarylamino group is preferred.

The aryl group in the diarylamino group may be monocyclic or polycyclic, and have 6 to 20 carbon atoms in total. Examples include phenyl, naphthyl, anthryl, phenanthryl, pyrenyl, perillenyl, and o-, m- and p-biphenyl groups, with the phenyl group being preferred. These aryl groups may further have substituents thereon. Such substituents include alkyl groups of 1 to 6 carbon atoms (preferably methyl) and substituted or unsubstituted aryl groups (preferably phenyl). Other preferred substituents on the aryl groups are the above-described groups represented by $R_{01}$ to $R_{04}$ in formula (2) excluding diarylaminoaryl groups. Where two or more substituents are incorporated, they may be the same or different. Also the substituent is preferably attached at the meta- or para-position relative to the position of N bond.

In formula (2), $r_{01}$, $r_{02}$, $r_{03}$, and $r_{04}$ each are an integer of 0 to 5, preferably 0 to 2, and especially equal to 0 or 1. Also preferably the sum of $r_{01}+r_{02}+r_{03}+r_{04}$ is at least 1, more preferably 1 to 4, and further preferably 2 to 4. $R_{01}$, $R_{02}$, $R_{03}$ and $R_{04}$ are preferably attached at the meta- or para-position relative to the position of N bond. Specifically all of $R_{01}$, $R_{02}$, $R_{03}$ and $R_{04}$ may be attached at the meta-position; all of $R_{01}$, $R_{02}$, $R_{03}$ and $R_{04}$ may be attached at the para-position; or $R_{01}$, $R_{02}$, $R_{03}$ and $R_{04}$ may be attached at the meta- and/or para-position. Where $r_{01}$, $r_{02}$, $r_{03}$ or $r_{04}$ is at least 2, the $R_{01}$ groups, $R_{02}$ groups, $R_{03}$ groups or $R_{04}$ groups may be the same or different.

Where a hole transporting layer and a hole injecting layer are formed in order from the light emitting layer side, it is preferred to use a compound of formula (1) in the hole transporting layer and a compound of formula (2) in the hole injecting layer. By combining such compounds, the electron blocking function is improved. In any case, it is preferred to use an aromatic tertiary amine compound having a benzidine skeleton and free of a phenylenediamine skeleton in the hole transporting layer and an aromatic tertiary amine compound having a phenylenediamine skeleton in the hole injecting layer.

The hole injecting layer preferably has a thickness of about 1 to 1,000 nm, more preferably about 1 to 100 nm, and the hole transporting layer preferably has a thickness of about 1 to 200 nm, more preferably about 5 to 100 nm. Where only one of these layers is provided, it preferably has a thickness of about 1 to 1,000 nm, more preferably about 10 to 500 nm.

<u>Electron transporting and/or injecting layer</u>

In the preferred embodiment of the invention, the EL device has an electron transporting and/or injecting layer as previously described in part. In embodiments other than the embodiment wherein an electron transporting layer

is provided and an electron injecting and transporting compound in that layer is used as a host material in the light emitting layer, it is yet preferred to provide an electron transporting and/or injecting layer (which is sometimes designated an electron injecting and transporting layer). In this case, the electron injecting and transporting compounds are preferably the above-described phenylanthracene derivatives and quinoline derivatives including organic metal complexes having 8-quinolinol or a derivative thereof as a ligand such as tris(8-quinolinolato)aluminum (Alq3), oxadiazole derivatives, perylene derivatives, pyridine derivatives, pyrimidine derivatives, quinoxaline derivatives, diphenylquinone derivatives, and nitro-substituted fluorene derivatives.

It is also preferred to use a phenylanthracene derivative of formula (A) and an aluminum complex having 8-quinolinol or a derivative thereof as a ligand, typically tris(8-quinolinolato)aluminum, and more specifically to use the former in the electron transporting layer on the light emitting layer side and the latter in the electron injecting layer on the cathode side. Note that the aluminum complexes having 8-quinolinol or a derivative thereof as a ligand are disclosed in WO 98/08360.

The electron injecting layer preferably has a thickness of about 1 to 1,000 nm, more preferably about 1 to 100 nm, and the electron transporting layer preferably has a thickness of about 1 to 500 nm, more preferably about 1 to 100 nm. Where only one of these layers is provided, it preferably has a thickness of about 1 to 1,000 nm, more preferably about 1 to 100 nm.

Cathode

The cathode is desirably made of a low resistance metal. This is of greater importance when the drive mode of conducting electric current across a plurality of light emitting devices at the same time is employed. Alternatively, a material which facilitates injection of electrons to an organic layer is selected and a low resistance metal may be laid thereon.

The cathode material used herein is preferably selected from halides and oxides of alkali metals such as Li, Na, K, Rb and Cs. Exemplary halides include lithium fluoride (LiF), lithium chloride (LiCl), lithium bromide (LiBr), lithium iodide (LiI), sodium fluoride (NaF), sodium chloride (NaCl), sodium bromide (NaBr), sodium iodide (NaI), rubidium fluoride (RbF), rubidium chloride (RbCl), rubidium bromide (RbBr), rubidium iodide (RbI), cesium fluoride (CsF), cesium chloride (CsCl), cesium bromide (CsBr), and cesium iodide (CsI). Exemplary oxides include lithium oxide ($Li_2O$) and sodium oxide ($Na_2O$). Of these, the halides of Rb and Cs are preferred, with the chlorides and iodides of Rb and Cs being especially preferred.

It is also acceptable that the alkali metal halide or oxide is formed as a lower layer, and a material having a low work function such as Li, Na, K, Mg, Al, Ag, In or an alloy containing at least one of these metals is stacked thereon. The cathode is desirably formed of fine crystal grains and especially amorphous. The total thickness of the cathode is preferably about 10 to 1,000 nm. Where the cathode consists of upper and lower layers, the lower layer preferably has a thickness of about 0.1 to 1 nm.

The use of the alkali metal halide or oxide as the cathode material is effective especially for devices having a blue light emitting layer because stable emission of blue light becomes possible. The blue light emission system requires more efficient electron injection and hole injection because the energy gap of the host in the blue light emission system is greater than in the green light emission system. Since prior art cathodes of MgAg or the like have inefficient electron injection, alkali metal materials having a higher efficiency are effective substitutes. This is because the alkali metal materials have a low work function. The work function of alkali metals remains unchanged even when they take the form of halides or oxides. When an electric field is applied, the halides or oxides can be reduced into metals. For these reason, the alkali metal halides and oxides are adequate electron injecting materials which are easy to handle. The improved adhesion between the organic film and the electrode is another advantage.

The use of the alkali metal halide or oxide as the cathode material is essential in the embodiment wherein the blue light emitting layer does not use as the host material an electron injecting and transporting compound or hole injecting and transporting compound in an electron transporting layer or hole transporting layer disposed adjacent to the light emitting layer.

The organic layer interfaced with the cathode may be doped with a metal such as lithium.

To prevent any contact with water or oxygen, the EL device is usually covered with a glass plate or enclosed with a metal can and sealed therewith. An inert gas such as rare gas or $N_2$ is contained in the sealed space.

At the end of electrode formation, aluminum or fluoride is evaporated or sputtered for providing an enhanced seal.

In the embodiment wherein tris(8-quinolinolato)-aluminum (Alq3) is used in the electron injecting and/or transporting layer and the cathode is formed by sputtering, a layer of a naphthacene derivative such as rubrene having a thickness of about 0.1 to 20 nm may intervene between the electron injecting and/or transporting layer and the cathode in order to preventing the electron injecting and/or transporting layer from being damaged by sputtering.

Anode

In order that the organic EL device produce flat light emission, at least one of the electrodes must be transparent or translucent. Since the cathode material is restricted as mentioned above, it is preferred to determine the material and thickness of the anode such that 80% or more of the emitted light may be transmitted thereby. For example, tin-doped indium oxide (ITO), zinc-doped indium oxide (IZO), $SnO_2$, Ni, Au, Pt, Pd, and doped polypyrrole are preferably used as the anode. Of these, ITO and IZO are especially preferred. Usually, ITO contains $In_2O_3$ and $SnO_2$ in stoichiometry although the oxygen content may deviate more or less from the stoichiometry. Similarly, IZO contains $In_2O_3$ and ZnO in stoichiometry although the oxygen content may deviate more or less from the stoichiometry. For ITO, an appropriate proportion of $SnO_2$ mixed with $In_2O_3$ is about 1 to 20%, more preferably about 5 to 12% by weight. For IZO, an appropriate proportion of ZnO mixed with $In_2O_3$ is about 12 to 32% by weight. The anode preferably has a thickness of about 10 to 500 nm. Since the drive voltage must be lower in order to make the device reliable, the anode is preferably formed of ITO having a sheet resistance of 10 to 30 Ω/square or up to 10 Ω/square, typically 0.1 to 10 Ω/square.

In a large size device for a display, aluminum wiring may be provided because of the accumulated resistance of ITO.

The transparent conductive film serving as the anode is generally deposited on the overcoat layer and patterned. Where the transparent conductive film has a too high resistance, a good conductor having a low resistivity is formed on an area other than the light emissive region as an auxiliary wiring and connected to the transparent conductive film for restraining a voltage drop. Examples of the low resistivity metal include metals such as Al, Ag, Au, Cu, Mo, W, Ta, Ni, and Cr, alloys based on these metals, and silicides having a low resistivity.

Where it is necessary to restrain current leakage between the anode and the cathode of an EL device, especially an organic EL device, edges of the transparent conductive film and the auxiliary wiring are covered with an insulating film. The step where the insulating film is contiguous to the light emitting surface of the transparent conductive film is forward tapered at an angle of less than 60 degrees for further restraining current leakage.

If necessary, a device isolating structure can be formed for isolating the cathodes of adjacent devices.

For producing panels in high yields, it is essential in practical manufacture that the device isolating structure have an overhang.

Thereafter, a material containing organic compound having a light emitting capability is deposited. The material may be formed as a single layer or plural layers. Where plural layers are formed, it suffices that at least the light emissive region be comprised of the organic compound.

Further preferably, a shield plate may be provided on the device in order to prevent the organic layers and electrodes from oxidation. In order to prevent the ingress of moisture, the shield plate is attached to the substrate through an adhesive resin layer for sealing. The sealing gas is preferably an inert gas such as argon, helium, and nitrogen. The inert gas should preferably have a moisture content of less than 100 ppm, more preferably less than 10 ppm, especially less than 1 ppm. The lower limit of the moisture content is usually about 0.1 ppm though not critical.

The shield plate is preferably selected from flat plates of transparent or translucent materials such as glass, quartz and resins, with glass being especially preferred. Alkali glass is preferred because of economy although other glass compositions such as soda lime glass, lead alkali glass, borosilicate glass, aluminosilicate glass, and silica glass are also useful. Of these, plates of soda glass without surface treatment are inexpensive and useful. Metal plates and plastic plates may also be used as the shield plate.

Using a spacer for height adjustment, the shield plate may be held at a desired height over the layer structure. The spacer may be formed from resin beads, silica beads, glass beads, and glass fibers, with the glass beads being especially preferred. Usually the spacer is formed from particles having a narrow particle size distribution while the shape of particles is not critical. Particles of any shape which does not obstruct the spacer function may be used. Preferred particles have an equivalent circle diameter of about 1 to 20 μm, more preferably about 1 to 10 μm, most preferably about 2 to 8 μm. Particles of such diameter should preferably have a length of less than about 100 μm. The lower limit of length is not critical although it is usually equal to or more than the diameter.

When a shield plate having a recess is used, the spacer may be used or not. When used, the spacer should preferably have a diameter in the above-described range, especially 2 to 8 μm.

The spacer may be premixed in a sealing adhesive or mixed with a sealing adhesion at the time of bonding. The content of the spacer in the sealing adhesive is preferably about 0.01 to 30% by weight, more preferably about 0.1 to 5% by weight.

Any of adhesives which can maintain stable bond strength and gas tightness may be used although UV curable epoxy resin adhesives of cation curing type are preferred.

In the organic EL structure of the invention, the substrate may be selected from amorphous substrates of glass and quartz and crystalline substrates of Si, GaAs, ZnSe, ZnS, GaP, and InP, for example. If desired, buffer layers of crystalline materials, amorphous materials or metals may be formed on such crystalline substrates. Metal substrates including Mo, Al, Pt, Ir, Au and Pd are also useful. Of these, glass substrates are preferred. Since the substrate is often

situated on the light output side, the substrate should preferably have a light transmittance as described above for the electrode.

The organic EL device for use in the EL display apparatus of the invention is generally of the dc or pulse drive type. It may be of the ac drive type. The applied voltage is generally about 2 to 30 volts.

For example, the organic EL device of the invention may have a stacked configuration of substrate/hole injecting electrode/hole injecting and transporting layer/light emitting layer/electron injecting and transporting layer/cathode (electron injecting electrode)/protective layer.

Such devices may be further stacked in multiple stages in a film thickness direction. Such a multi-stage configuration is effective for adjusting or multiplying the color of emitted light.

Inorganic EL device

The inorganic EL device has a basic structure including a structure consisting of an electrically insulating substrate on which a first electrode and a first insulator layer are formed in a predetermined pattern, a light emitting layer having an electroluminescent capability formed thereon by vacuum evaporation, sputtering or CVD, a second insulator layer, and a second electrode layer preferably in the form of a transparent electrode. Preferably the material of at least one of the first and second insulator layers is a specific composition to be described below.

The light emitting layer is the same as in conventional EL devices. The second electrode is an ITO film which is generally formed by a conventional thin-film process.

The preferred materials for the light emitting layer are described, for example, TANAKA Shosaku, "Recent Technical Trend of Displays" in monthly magazine Display, April 1998, pp. 1-10. More particularly, the materials capable of red light emission include ZnS and Mn/CdSSe, the materials capable of green light emission include ZnS:TbOF, ZnS:Tb, and ZnS:Tb, and the materials capable of blue light emission include SrS:Ce, (SrS:Ce/ZnS)n, $CaCa_2S_4$:Ce, and $Sr_2Ga_2S_5$:Ce.

SrS:Ce/ZnS:Mn is known as a material capable of white light emission.

In particular, better results are obtained when the present invention is applied to the EL device having a blue light emitting layer of SrS:Ce reported by X. Wu, "Multicolor Thin-Film Ceramic Hybrid EL Displays" in IDW (International Display Workshop), 1997, pp. 593-596.

The thickness of the light emitting layer is not critical. Too thick a layer would require an increased drive voltage whereas too thin a layer would result in a drop of luminous efficiency. Specifically the light emitting layer has a thickness of about 100 to 1,000 nm, especially about 150 to 500 nm although the thickness depends on a particular fluorescent material used.

The light emitting layer may be formed by vapor phase deposition processes. The vapor phase deposition processes include physical vapor phase deposition processes such as sputtering and evaporation and chemical vapor phase deposition (CVD) processes, with the CVD being preferred.

As described in the above-referred article of IDW, an electron beam (EB) evaporation process in a $H_2S$ atmosphere is advantageously employed to form a light emitting layer of SrS:Ce because the resulting light emitting layer is of high purity.

The formation of the light emitting layer is preferably followed by heat treatment. Heat treatment may be effected after the electrode layer, insulator layer and light emitting layer are formed on the substrate. Alternatively, cap anneal may be effected after the electrode layer, insulator layer, light emitting layer, insulator layer and optionally electrode layer are formed on the substrate. The cap anneal process is preferred in most cases. The temperature of heat treatment preferably ranges from about 600°C to the sintering temperature of the substrate, more preferably from about 600 to 1,300°C, especially from about 800 to 1,200°C while the time is about 10 to 600 minutes, especially about 30 to 180 minutes. The atmosphere for annealing is $N_2$, Ar, He or $N_2$ containing less than 0.1% of $O_2$.

As the transparent electrode, materials having a relatively low resistivity are preferred in order to effectively develop an electric field. Illustratively, materials based on tin-doped indium oxide (ITO), zinc-doped indium oxide (IZO), indium oxide ($In_2O_3$), tin oxide ($SnO_2$) and zinc oxide (ZnO) are preferable. These oxides may deviate more or less from their stoichiometry. For ITO, an appropriate proportion of $SnO_2$ mixed with $In_2O_3$ is about 1 to 20%, more preferably about 5 to 12% by weight. For IZO, an appropriate proportion of ZnO mixed with $In_2O_3$ is about 12 to 32% by weight.

When a ferroelectric material of a specific composition to be described below is used as the first insulator layer, it is preferred that the substrate, first electrode and first insulator layer constitute a multilayer ceramic structure. For the first insulator layer and the substrate, the same material or similar materials may be used.

The first insulator layer is formed of barium titanate base ferroelectric material which contains barium titanate as the main component and silicon oxide and at least one of magnesium oxide, manganese oxide, barium oxide and calcium oxide as the auxiliary component. Provided that barium titanate is $BaTiO_3$, magnesium oxide is MgO, manganese oxide is MnO, barium oxide is BaO, calcium oxide is CaO, and silicon oxide is $SiO_2$, the proportion of the respective compounds in the insulator layer is such that 0.1 to 3 mol, preferably 0.5 to 1.5 mol of MgO, 0.05 to 1.0 mol,

preferably 0.2 to 0.4 mol of MnO, 2 to 12 mol of BaO + CaO, and 2 to 12 mol of $SiO_2$ are present per 100 mol of $BaTiO_3$.

The ratio of (BaO+CaO)/$SiO_2$ is preferably from 0.9 to 1.1 though not critical. BaO, CaO and $SiO_2$ may be contained in the form of $(Ba_xCa_{1-x}O)_y \cdot SiO_2$. To produce a dense sintered body, the range of $0.3 \le x \le 0.7$ and $0.95 \le y \le 1.05$ is preferred.

An appropriate content of $(Ba_xCa_{1-x}O)_y \cdot SiO_2$ is about 1 to 10%, especially about 4 to 6% by weight based on the total of $BaTiO_3$, MgO and MnO.

No particular limits are imposed on the oxidation state of the respective oxides as long as the contents of metal elements forming the respective oxides fall within the above-defined range.

As an additional auxiliary component, the first insulator layer preferably contains yttrium oxide in an amount of less than 1 mol calculated as $Y_2O_3$ per 100 mol calculated as $BaTiO_3$ of barium titanate. The lower limit of the $Y_2O_3$ content is not critical although a content of at least 0.1 mol is preferred in order for yttrium oxide to exert a satisfactory effect. When yttrium oxide is contained, an appropriate content of $(Ba_xCa_{1-x}O)_y \cdot SiO_2$ is about 1 to 10%, especially about 4 to 6% by weight based on the total of $BaTiO_3$, MgO, MnO and $Y_2O_3$.

The first insulator layer may contain a further compound although it is preferred to substantially exclude cobalt oxide which can increase a capacitance change.

The contents of auxiliary components are limited for the following reason. If the content of magnesium oxide is less than the above-defined range, temperature properties of capacitance deteriorate. A higher content of magnesium oxide beyond the above-defined range invites an acute degradation of sintering and insufficient consolidation, resulting in an increased change with time of dielectric strength and the difficulty to use a thin film.

If the content of manganese oxide is less than the above-defined range, good chemical reduction resistance is lost so that when nickel liable to oxidation is used in the first electrode, a substantial change of dielectric strength may occur to make it difficult to use a thin film. A higher content of manganese oxide beyond the above-defined range invites a substantial change with time of capacitance and a substantial change with time of the luminance of the light emitting device.

If the content of BaO+CaO, $SiO_2$ or $(Ba_xCa_{1-x}O)_y \cdot SiO_2$ is too low, there occur a substantial change with time of capacitance and a substantial change with time of the luminance of the light emitting device. Too high a content invites an acute drop of dielectric constant, a ramp of emission start voltage, and a drop of luminance.

Yttrium oxide is effective for improving the durability of dielectric strength. A higher content of yttrium oxide beyond the above-defined range may invite a drop of capacitance, degradation of sintering and insufficient consolidation.

The first insulating layer may further contain aluminum oxide. The addition of aluminum oxide leads to a lower sintering temperature. The content of aluminum oxide calculated as $Al_2O_3$ is preferably up to 1% by weight based on the entire first insulator layer material. Too high a content of aluminum oxide rather precludes the first insulator layer from being sintered.

The average grain size of the first insulator layer is not critical although the selection of the above-defined composition ensures fine crystal grains. Usually the average grain size is about 0.2 to 0.7 μm.

When the above-described multilayer ceramic structure is used, the conductive material of the first electrode layer is not critical. Use may be made of conductive materials containing one or more metals selected from among Ag, Au, Ni, Pd, Pt, Cu, Fe, Co, Mo and W as the main component or alloys thereof.

When the above-described multilayer ceramic structure is used, the substrate material is not critical. Use may be made of $Al_2O_3$ and $Al_2O_3$ having $SiO_2$, MgO or CaO added thereto for the purpose of adjusting the sintering temperature, for example. When the multilayer ceramic structure is not used, a glass substrate as used in conventional EL devices may be used. High-melting glass is preferred since it allows for treatment at higher temperature.

The above-described multilayer ceramic structure is manufactured by conventional processes as described above. More particularly, a ceramic raw material powder to form a substrate is mixed with a binder to form a paste, which is cast to form green sheets. A first electrode serving as the internal electrode within the ceramic structure is printed onto each green sheet as by screen printing.

Next, the green sheets are baked if necessary, and a paste prepared by mixing a highly dielectric material powder with a binder is printed thereon as by screen printing. The sheet stack is fired to produce a multilayer ceramic structure.

Following binder removal, firing is effected at a temperature of about 1,200 to 1,400°C, preferably about 1,250 to 1,300°C for several hours to several tens of hours.

During firing, an oxygen partial pressure of $10^{-8}$ to $10^{-12}$ atm. is preferably employed. Since the first insulator layer provides a reducing atmosphere under this condition, an inexpensive base metal, for example, any one of Ni, Cu, W and Mo or an alloy based on any one of these metals may be used as the electrode. If necessary, a layer for preventing oxygen diffusion, for example, a layer of the same composition as the first insulator layer may be formed between the green sheet and the first electrode pattern before firing.

Upon firing in a reducing atmosphere, a composite substrate is preferably annealed. Anneal is a treatment

for re-oxidizing the first insulator layer, by which a change with time of dielectric strength is reduced.

The oxygen partial pressure of the annealing atmosphere is preferably at least $10^{-6}$ atm., especially $10^{-5}$ to $10^{-4}$ atm. An oxygen partial pressure below the range obstructs re-oxidation of the insulator layer or dielectric layer whereas an oxygen partial pressure beyond the range tends to oxidize the internal conductors.

Upon annealing, the holding temperature is up to 1,100°C, especially 500 to 1,000°C. If the holding temperature is below the range, there is a tendency that oxidation of the insulator layer or dielectric layer becomes insufficient, resulting in a short lifetime. Beyond the range, the electrode layer can not only be oxidized to lower the capacitance, but react with the insulating and dielectric materials to shorten the lifetime.

It is noted that the annealing step may consist of heating and cooling steps. In this case, the temperature holding time is zero and the holding temperature is equal to the highest temperature. The temperature holding time is preferably 0 to about 20 hours, especially about 2 to 10 hours. As the surrounding gas, humidified nitrogen gas is preferably used.

For the manufacture of the multilayer ceramic structure, any of various processes other than the above-described process may be employed. A few exemplary processes are described below.

(1) There is furnished a film sheet of PET or the like, onto which a paste containing a selected dielectric material for the first insulator layer is printed over the entire surface by a printing technique or the like. A paste containing a conductive material for the first electrode is formed thereon in a pattern by a screen printing technique or the like. A green sheet of a paste containing alumina for the substrate and additives is formed thereon, constructing a multilayer structure. The multilayer structure is removed from the film sheet and sintered. In this example, a light emitting layer and other layers are formed on the surface of the multilayer structure which has been in contact with the film sheet. Therefore this process is characterized by providing a very flat surface.

(2) There is furnished a ceramic substrate such as pre-fired alumina. A paste containing a conductive material for the first electrode is formed on a substrate surface in a pattern by a printing technique or the like. A paste containing a selected dielectric material for the first insulator layer is printed thereon over the entire surface by a screen printing technique or the like. The layers are sintered together with the substrate.

In the EL device, the areas defined between orthogonal crossing first and second electrodes produce light emission. The electrodes serves for both the function of supplying electric current and the function of defining pixels. The electrodes are formed to any pattern as desired.

When the substrate, first electrode and first insulator layer constitute the multilayer ceramic structure, the pattern of the first electrode can be readily formed by a screen printing technique. In general, the EL device display does scarcely require an extremely fine electrode pattern and therefore, the screen printing technique is acceptable, with the advantage of possible formation of a large area electrode at a low cost. Photolithography may be used where a fine electrode pattern is required.

On the multilayer ceramic structure described above, a light emitting layer and other layers are formed by suitable thin-film processes such as evaporation and sputtering, yielding an inorganic EL device.

<u>Example 1</u>

Referring to FIGS. 7 to 14, there is illustrated an example in which five display colors are obtained using three color filters. FIGS. 7, 9, 11 and 13 are plan views, and FIGS. 8, 10, 12 and 14 are cross-sectional views taken along lines A-A' in FIGS. 7, 9, 11 and 13, respectively. FIGS. 7 and 8 illustrate pigment-dispersed color filters formed on a substrate 1 such that a strip of alternately disposed blue color filter sections 2B and green color filter sections 2G, a blue color filter strip 2B, a green color filter strip 2G, a red color filter strip 2R, and a color filter-less strip (only overcoat) 3a are arranged from above to below in FIG. 7. The blue and green color filter sections 2B and 2G are formed in stripe at a pitch of 150 μm. Over the color filters, an overcoat layer 3 is formed, and $SiO_2$ is deposited thereon as a cap layer 4.

FIGS. 9 and 10 show the state wherein ITO is deposited and patterned as a transparent conductive film 5. ITO was deposited to a thickness of 100 nm, a striped resist pattern was formed thereon by photolithography, and etching was effected with a commercially available etching solution, typically a mixed acid of $HCl:HNO_3:H_2O$ = 6:1:19.

FIGS. 11 and 12 illustrate the state wherein an organic layer 6 is formed on the transparent conductive film 5 by depositing a material containing an organic compound having a light emitting capability after removal of the resist. Poly(thiophene-2,5-diyl) was deposited to a thickness of 10 nm as a hole injecting layer, and TPD doped with 1 wt% of rubrene was co-evaporated to a thickness of 5 nm as a hole transporting layer and yellow light emitting layer. An appropriate concentration of rubrene is about 0.1 to 10% by weight because efficient light emission occurs at this concentration. The concentration is determined in accordance with the color balance of light emission and also depends on the light intensity and wavelength spectrum of a blue light emitting layer to be subsequently formed. Thereafter, 4'-bis[(1,2,2-triphenyl)ethenyl]biphenyl was deposited to 50 nm as the blue light emitting layer, and Alq3 deposited to 10

nm as an electron transporting layer.

Finally, an Al-Li alloy and Al were evaporated in vacuum to form a cathode 7 as shown in FIGS. 13 and 14.

The thus obtained panel was operated to emit light. Sky blue, blue, green, red, and white colored light emissions were viewed from upper to lower columns.

Example 2

FIG. 15 illustrates an exemplary display panel 100 for an automotive audio set. A character information display section 101 provides a white display, a spectral indicator section 103 includes upper portions 103a of yellow and lower portions 103b of sky blue, and a peak indicator section 102 includes an upper portion 102a of red, a middle portion 102b of yellow and a lower portion 102c of blue. The panel 100 at the center further includes a time display section 104 of green. The color assignment to a power display section, operating mode display section and other sections is omitted.

Yellow was formed by mosaic arrangement of green and red color filter sections in an area ratio of 1:2, and sky blue was formed by mosaic arrangement of green filter sections and color filter-less sections in an area ratio of 4:1. The forming method is the same as in Example 1.

ITO was deposited and patterned as desired to form a transparent conductive film. TiN of 50 nm thick and Al of 300 nm thick were deposited and patterned as an auxiliary wiring. A positive resist of 1 μm thick was formed as an insulating film, except for the light emitting portion and the wiring lead portion. The positive resist was fully cured at a temperature of 180°C.

Next, a device isolating structure for isolating cathodes was formed. First, polyimide was coated to 2 μm and dried at 115°C, and a resist was coated to 3 μm and patterned by photolithography. By immersing in a developer solution for an ample time, the polyimide beneath the resist was etched, obtaining a structure having the overhanging resist. This structure and process is as disclosed in JP-A 9-330792 and JP-A 10-172765. Using a metal mask having an overhang structure as disclosed in JP-A 9-41663, a hole injecting layer, a hole injecting layer and yellow light emitting layer, and a blue light emitting layer were formed as in Example 1. With the vacuum kept, an Al-Li alloy of 5 nm thick and Al of 300 nm thick were deposited by sputtering. Finally SiON was deposited to 50 nm by sputtering.

Al and SiON fully spread beneath the overhang of the device isolating structure, completely covering the organic layer and the Al-Li alloy layer.

A glass plate was bonded to the structure in order to prevent any contact with water and oxygen, and a fully dry inert gas such as rare gas or $N_2$ was contained, completing the panel.

Despite the color filters of only three colors, six colors including white, red, green, blue, yellow and sky blue could be displayed by devising the arrangement of the color filters. The display panel had a definite visibility and large information-carrying capacity.

Benefits of the Invention

The EL display apparatus of the invention can afford at a low cost a display apparatus using a reduced number of filter materials and capable of displaying a greater number of colors than the number of filter materials.

**Claims**

1. An EL display apparatus comprising an EL device unit having a light output side and at least two different color filters inclusive of a colorless filter arranged in parallel on the light output side, wherein light emitted by the EL device unit is transmitted by the at least two different color filters to constitute a display unit.

2. The EL display apparatus of claim 1 wherein said color filters are chromatic color filters or fluorescent conversion filters.

3. The EL display apparatus of claim 1 wherein said color filters are arranged in a stripe, mosaic or delta pattern.

4. The EL display apparatus of claim 1 wherein the light emitted by the EL device unit is monochromatic.

5. The EL display apparatus of claim 1 wherein the light emitted by the EL device unit is generally white.

6. The EL display apparatus of claim 1 capable of displaying at least four colors.

7. The EL display apparatus of claim 1 wherein any one of the color filters includes a portion which is transparent to

at least visible light so that the light emitted by the EL device unit is transmitted by the transparent portion to the outside without a substantial change of its color.

**8.** The EL display apparatus of claim 1 wherein the tone of the display unit is adjusted by the ratio in surface area between said at least two different color filters.

**9.** The EL display apparatus of claim 1 wherein said EL device unit includes a portion having a light emitting capability, which portion is comprised primarily of an organic material.

**10.** The EL display apparatus of claim 9 wherein the portion having a light emitting capability contains a dopant, and the tone of the display unit is adjusted by the concentration of the dopant.

**11.** The EL display apparatus of claim 1 including a segment display portion and a dot matrix display portion, the number of color filter materials in the segment display portion being smaller than the number of color filter materials in the dot matrix display portion.

FIG. 1

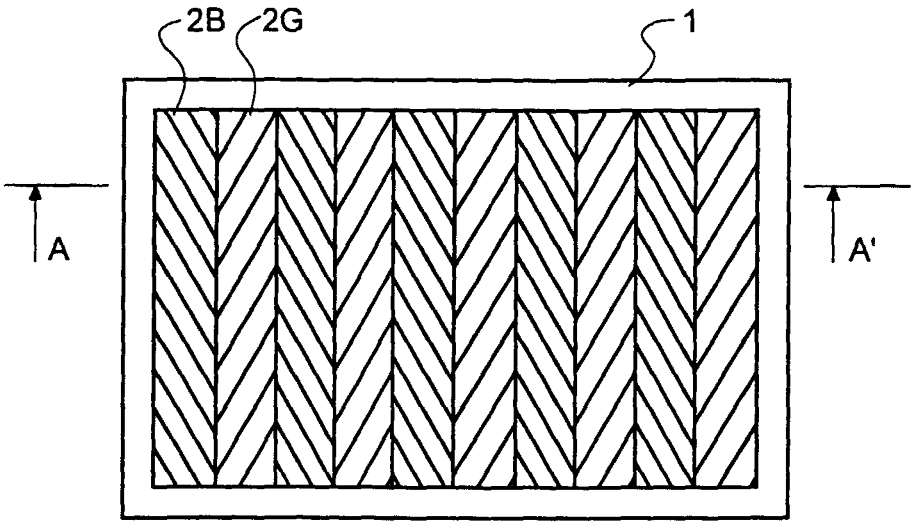


FIG. 2

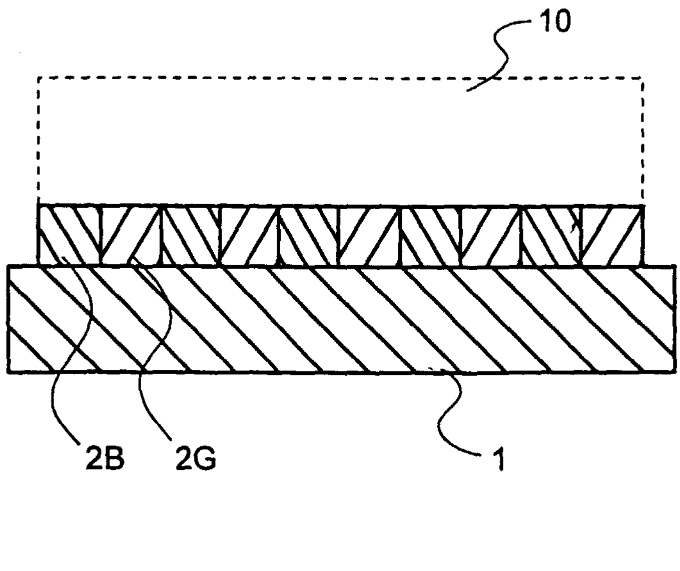

FIG. 3

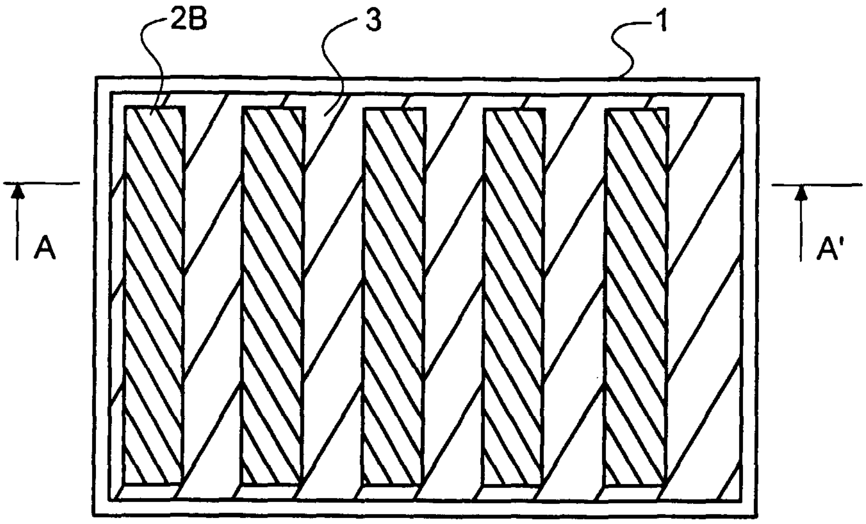


FIG. 4

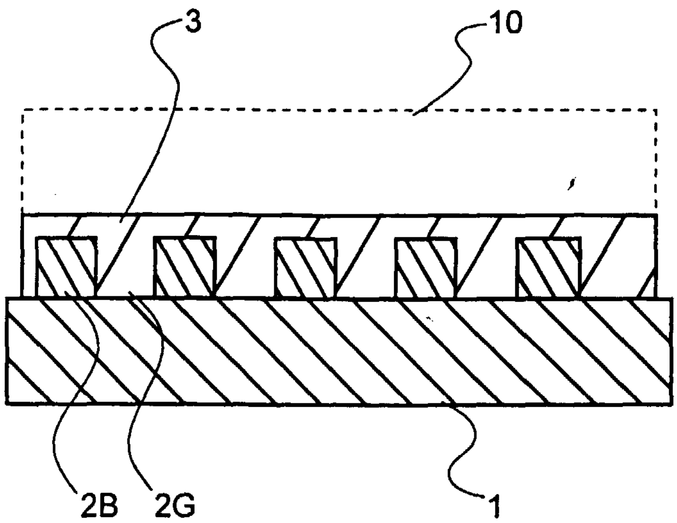

FIG. 5

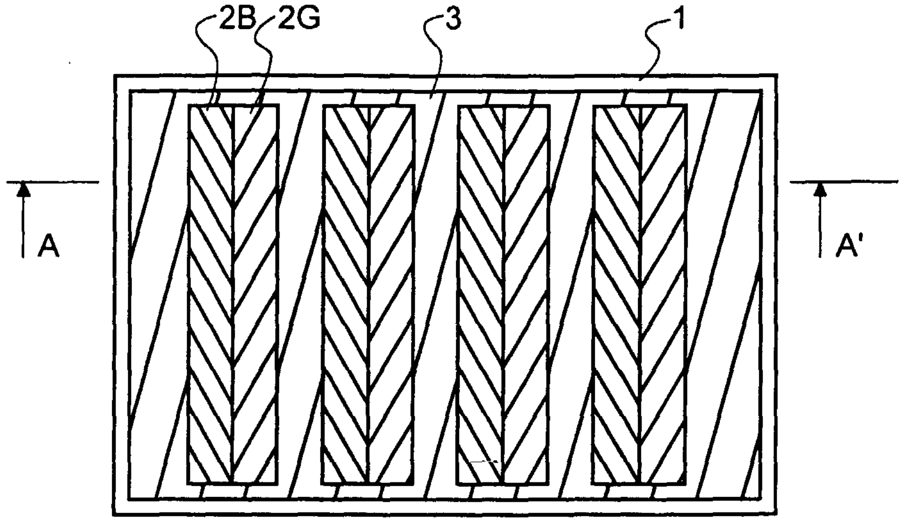


FIG. 6

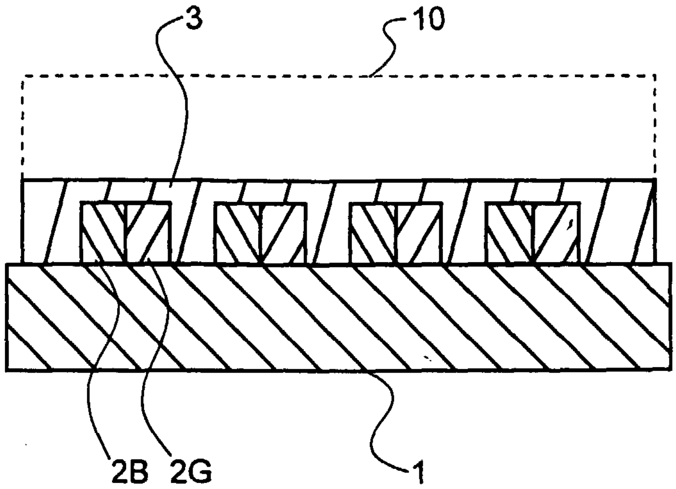

FIG. 7

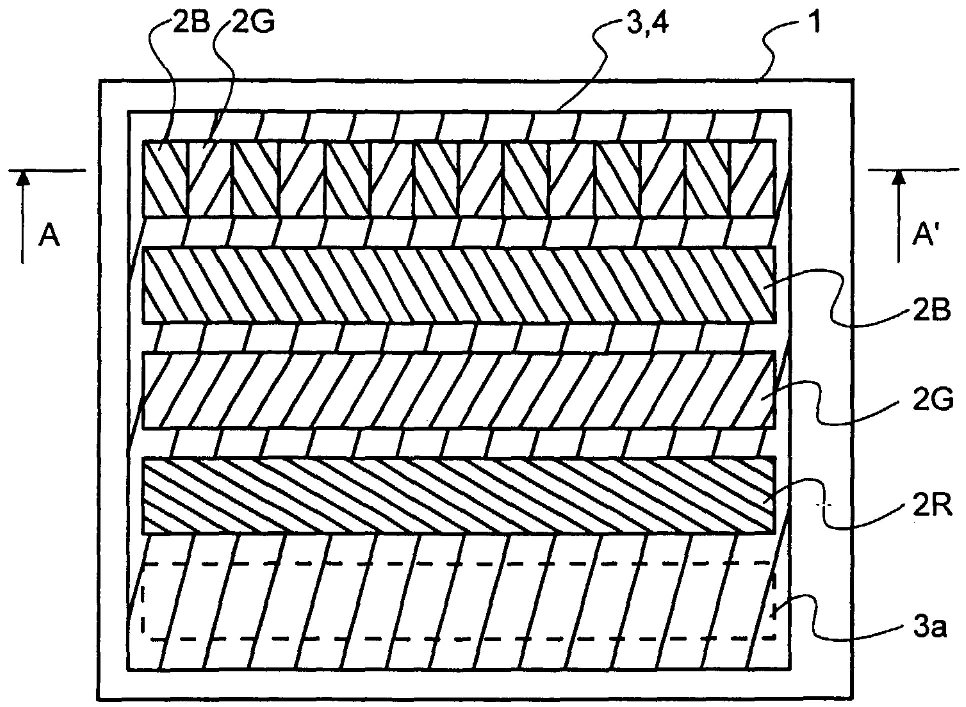


FIG. 8

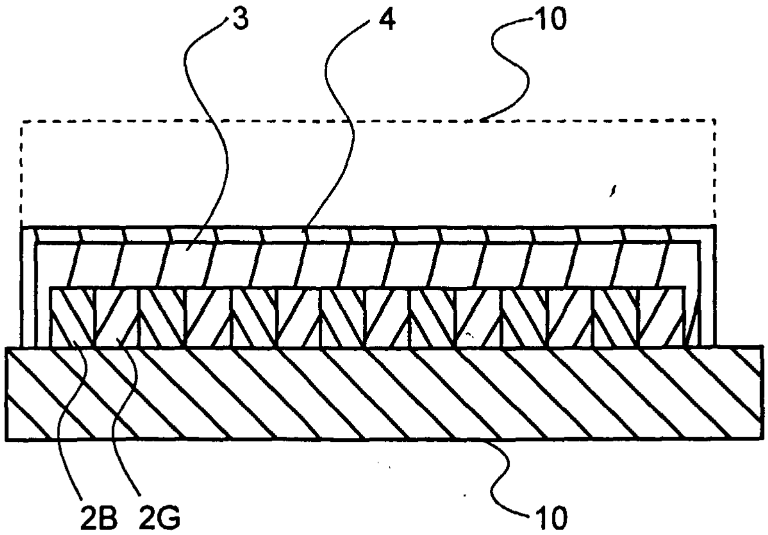

FIG. 9

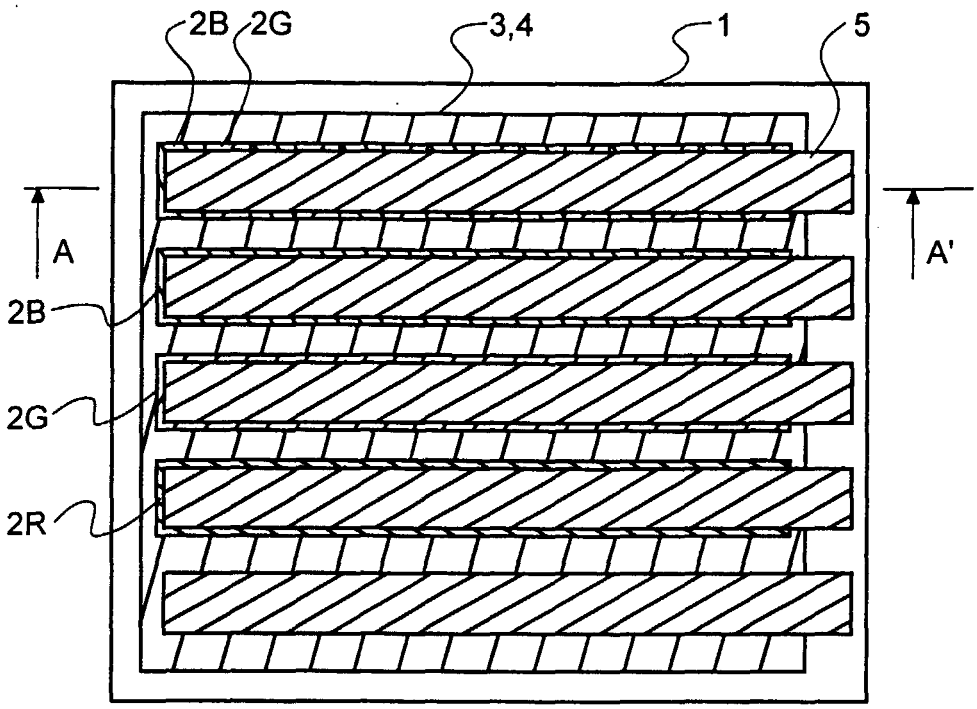


FIG. 10

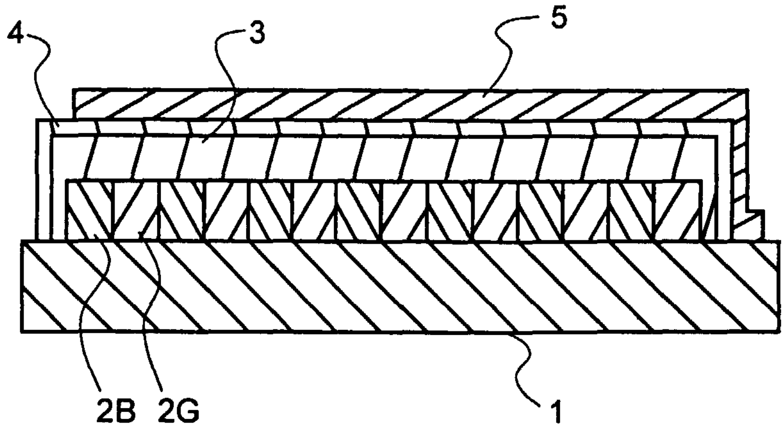

FIG. 11

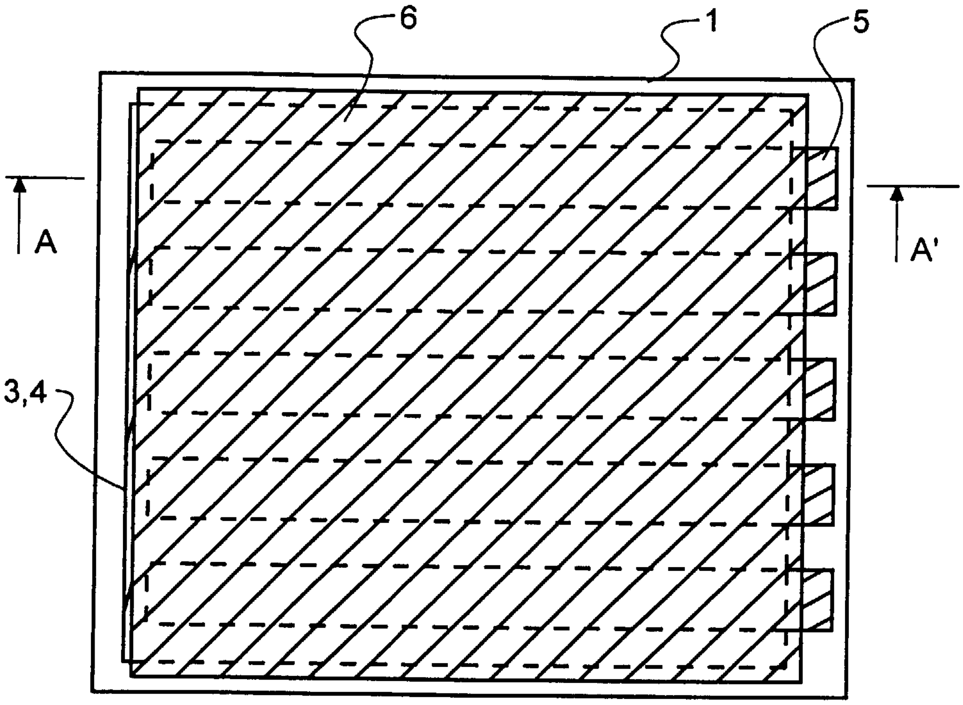


FIG. 12

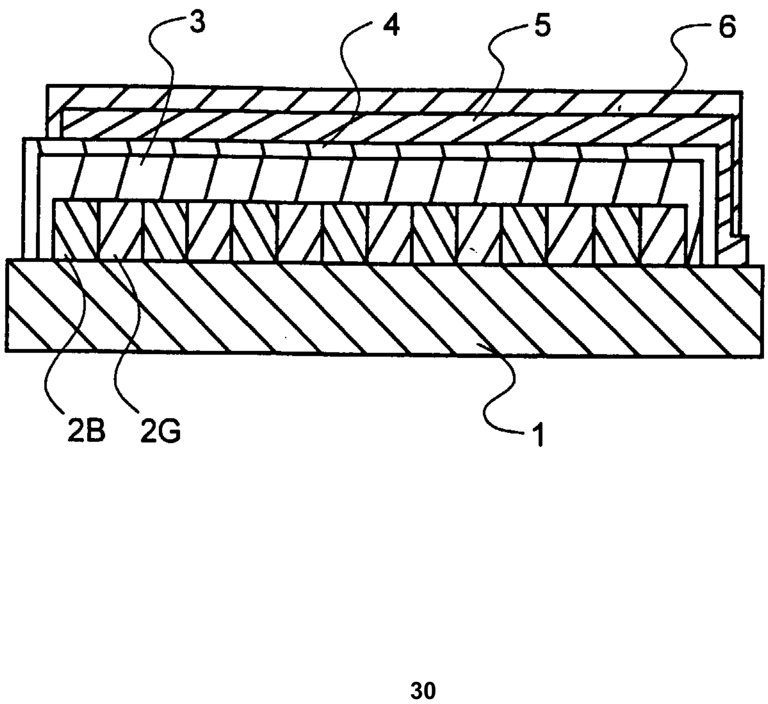

FIG. 13

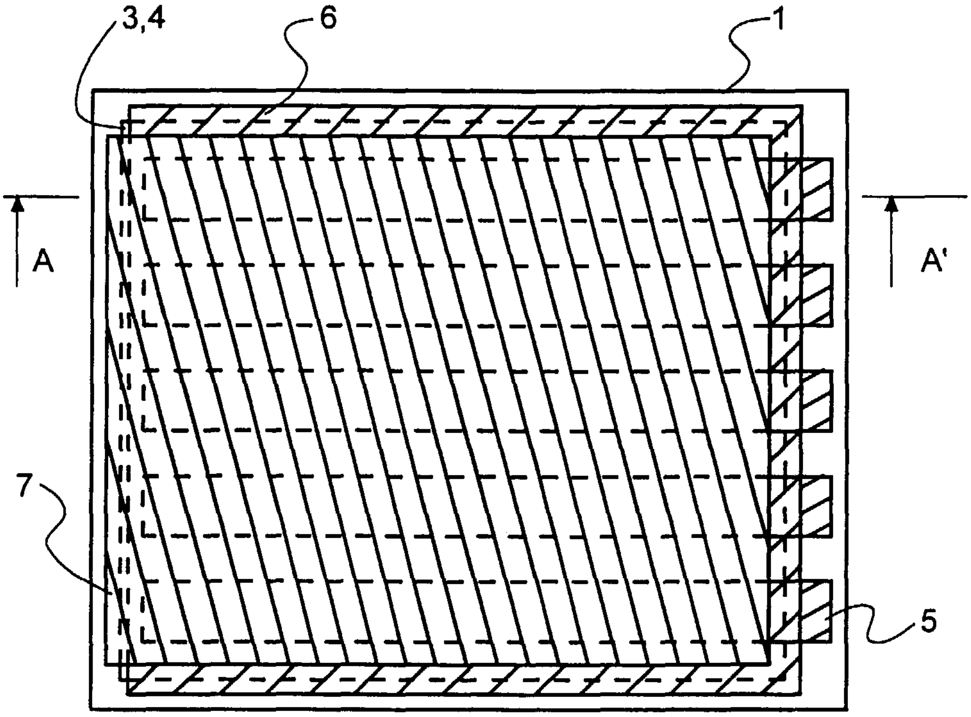


FIG. 14

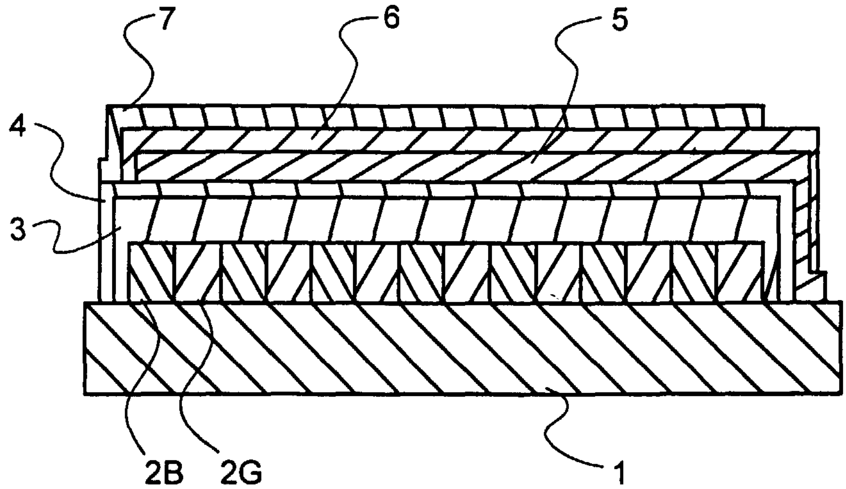

FIG. 15

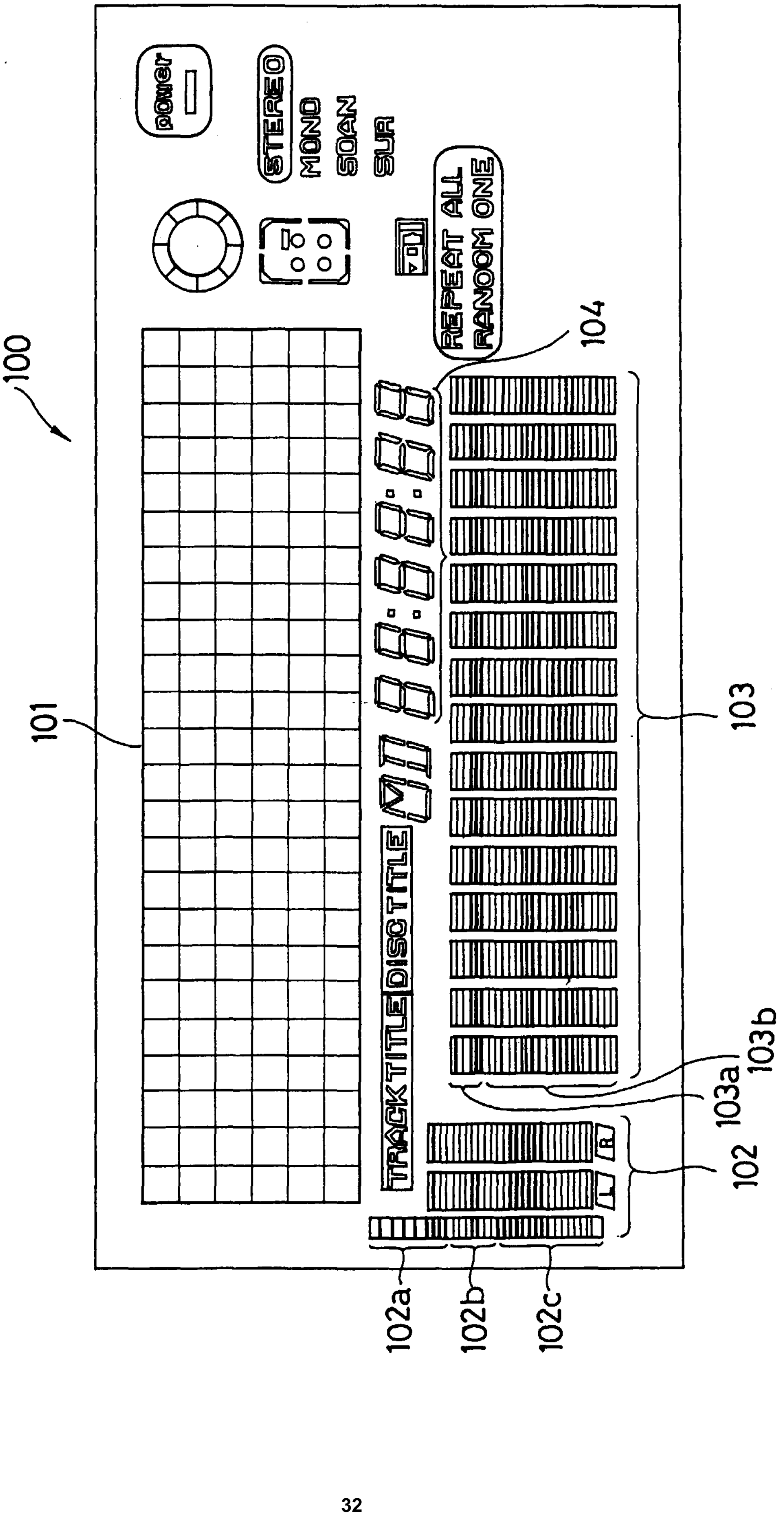
100
101
102
102a
102b
102c
103
103a
103b
104
power
STEREO
MONO
SUR
REPEAT ALL
TRACK TITLE
DISC TITLE
L
R